(19) Europäisches Patentamt
European Patent Office
Office européen des brevets

(11) **EP 1 719 990 B1**

(12) **EUROPÄISCHE PATENTSCHRIFT**

(45) Veröffentlichungstag und Bekanntmachung des Hinweises auf die Patenterteilung:
**06.11.2013 Patentblatt 2013/45**

(51) Int Cl.:
*G01L 1/22* (2006.01)          *G01K 7/24* (2006.01)
*G01R 27/02* (2006.01)

(21) Anmeldenummer: **05009872.2**

(22) Anmeldetag: **06.05.2005**

(54) **Verfahren und Vorrichtung zur Temperaturkompensation einer Messbrücke**

Method and apparatus for temperature compensation of a sensing bridge

Méthode et appareil pour compensation de température d'un pont de mesure

(84) Benannte Vertragsstaaten:
**DE FR GB IT**

(43) Veröffentlichungstag der Anmeldung:
**08.11.2006 Patentblatt 2006/45**

(73) Patentinhaber: **Acam-messelectronic GmbH**
**76297 Stutensee-Blankenloch (DE)**

(72) Erfinder:
• **Braun, Augustin**
**76689 Karlsdorf-Neuthard (DE)**

• **Bahnmüller, Friedrich**
**76199 Karlsruhe (DE)**

(74) Vertreter: **Lempert, Jost**
**LICHTI Patentanwälte**
**Postfach 41 07 60**
**76207 Karlsruhe (DE)**

(56) Entgegenhaltungen:
**EP-A- 0 271 827      EP-A- 1 251 357**
**EP-A- 1 279 964      CH-A- 687 349**
**US-A- 4 176 556**

**Beschreibung**

Die Erfindung betrifft ein Verfahren zur Temperaturkompensation einer Widerstands-Messbrücke, wie insbesondere einer Wheatstonebrücke, sowie eine Vorrichtung zur Temperaturkompensation einer Messbrücke zur Durchführung dieses Verfahrens..

Die Messung von Widerständen, insbesondere durch Dehnungsmessstreifen gebildeten Widerständen, die zur Messung in Form einer Messbrücke, insbesondere einer Wheatstonebrücke, angeordnet werden, zeigen einen Temperaturgang, d.h. der Widerstandswert ändert sich mit der Temperatur. Eine Druckmesszelle mit solchen Widerstandsmessstreifen weist beispielsweise auf einer Siliziumbasis als druckempfindlichem Element eine dünne Membran auf. Ist diese aus dem Siliziumkörper ausgeätzt und lokal mit Fremdatomen in den Siliziumkristall eindiffundierten oder implantierten Fremdatomen versehen, so bilden sich Zonen mit geänderter Leitfähigkeit, die elektrisch als Leiter bzw. lokale Widerstände in Erscheinung treten. Sobald durch einen Druckkanal ein Druck auf die Messzelle einwirkt, deformiert sich die dünne Siliziummembran. Durch die auftretenden inneren Kräfte wird die molekulare Struktur des Kristalls reversibel verändert. Insbesondere in den eindiffundierten Widerstandsgebieten finden im Kristall starke Potentialverschiebungen statt, die zu einer messbaren Veränderung der elektrischen Werte führen. Durch die Verschaltung der lokalen Widerstandgebiete als Messbrücke erhält man bei Anlegen von Spannung druckabhängige elektronische Signale, wobei allerdings, wie gesagt, die Widerstandsgebiete einen Temperaturgang aufweisen können. Das gattungsgemäße Verfahren und die gattungsgemäße Vorrichtung werden so beispielsweise bei der Bestimmung von Widerstandswerten von derartigen Dehnungsmessstreifen-Anordnungen und damit zur Messung von Dehnungen, die durch Kräfte, Drücke, Drehmomente und Gewichte bewirkt werden und damit zur Bestimmung der letzteren genannten Größen eingesetzt.

Der genannte Temperaturgang solcher Sensoren muss bereits bei Anwendungen mit eingeschränktem Temperaturbereich (-10...+40°C), wie beispielsweise Haushalts- oder Verkaufswaagen mit zusätzlichen Maßnahmen kompensiert werden. Bei den meisten industriellen und auch automobilen Anwendungen ist der Temperaturbereich größer (-40 .. 125°C) und die Dehnungsmessstreifen müssen sorgfältig an den Einsatzbereich angepasst werden und oft unter Zusatzaufwand mit einer Temperaturmessung versehen werden. In jedem Fall muss eine Produktion stabil und reproduzierbar eingefahren sein, damit die Anwendungen ohne zusätzliche Abgleichmaßnahmen den gewünschten Temperaturgang erreichen. Ein nachträglicher Abgleich der vergossenen Messbrücken ist oft nicht mehr möglich oder erzeugt erhebliche Zusatzkosten.

Bei Messbrücken wird eine konstante Spannung über der Brücke und einen Kompensationswiderstand angelegt und die Differenzspannung zwischen den Brückenzweigen gemessen.

Die Unterdrückung eines thermischen Ausgangssignals ohne Last wird durch die Verhältnisbildung der Widerstände beherrscht, aber nur dann, wenn an den Brückenabgriffen keine Differenzspannung anliegt und somit für die Brückenwiderstände die Abgleichbedingung $R_1 / R_3 = R_2 / R_4$ gilt.

Beispielsweise kann sich der Widerstandswert aller vier Widerstände einer Messbrücke aufgrund der Wärmeausdehnung der Auflagefläche verändern. Da die Wärmeausdehnung jedoch alle vier Brückenwiderstände gleichmäßig betrifft, bleibt das Verhältnis der Widerstände unverändert und somit bleibt auch die Abgleichbedingung erfüllt. Bei solchen Brücken werden Abgleichwiderstände für den Brückennullabgleich eingefügt, die häufig mechanisch abgeglichen werden.

Im Fall einer verstimmten Brücke mit gedehntem Dehnungsmessstreifen kommen weitere Temperaturabhängigkeiten hinzu. Bei den meisten Widerständen ist der k-Faktor, die Beziehung zwischen der Dehnung und der daraus resultierenden Widerstandsänderung, temperaturabhängig. Bei Kraftmessungen ist auch der Elastizitätsmodul, die Beziehung zwischen der Dehnung der Auflagefläche der Dehnungsmessstreifen und der gemessenen Kraft, temperaturabhängig.

Der Temperaturgang des k-Faktors oder des Elastizitätsmoduls wird im Falle einer belasteten Wheatstonebrücke durch die Verhältnisbildung der Widerstandswerte nicht vollständig unterdrückt. Es bleibt ein temperatur- und verstimmungsabhängiger Fehler in der gemessen Brückendifferenzspannung, der sogenannte Span-Fehler.

Eine heute häufig angewendete Methode, den Span-Fehler zu minimieren, ist das Einbringen von ein oder zwei Serienwiderständen in die Spannungsversorgung der Brücke. Diese Serienwiderstände besitzen eine Temperaturabhängigkeit, welche der des Span-Fehlers entgegengesetzt ist und z.B. mit steigender Temperatur durch den Widerstandsanstieg die effektive Brückenspannung reduziert und dadurch die Brückendifferenzspannung konstant hält. Über einen begrenzten Temperaturbereich (z.B. -10 C .... +40 C) kann man mit dieser Methode sehr gute Ergebnisse erzielen. Dazu sind allerdings diese Kompensationswiderstände möglichst genau auf die Gegebenheiten von Dehnungsmessstreifen und Lastkörper anzupassen.

Darüber hinaus kommt es durch unvermeidbare Toleranzen der Dehnungsmessstreifen-Widerstände ohne weitere Abgleichmaßnahmen bereits zu einem Brückenausgangssignal ohne Belastung, den Offset-Fehler. Damit die Span Kompensation nicht zu zusätzlichen temperaturabhängigen Offset-Fehlern führt, muss die Brückenspannung ohne Last auf sehr nahe 0 abgeglichen werden. Wäre dies nicht der Fall, würde die Reduktion der Brückenspannung durch den Span-Widerstand auch in gleichem Maße die Offsetspannung reduzieren. Eine nur mathematisch (z.B. im angeschlossenen Mikroprozessor) zu null korrigierte Offsetspannung würde dadurch über die Temperatur schwanken.

Zur Berichtigung dieser Fehler wird die unverstimmte, unbelastete Brückenspannung zu null Volt abgeglichen und ein passender Kompensationswiderstand für die Kompensation des Ausgangssignals der Brücke appliziert. Die Elektronik, welche das Brückensignal dann auswertet, ist in diese Abgleichmaßnahmen nicht mit eingebunden. Nachteilig bei dieser Vorgehensweise sind aufwändige und hohe Anforderungen an die Reproduzierbarkeit sowie die Konstanz in der Fertigung. Weiterhin müssen die notwendigen Abgleichmaßnahmen vor der Herstellung der Messzellen schon bekannt sein. Ansonsten erhöhen sich die Abgleichkosten nach Herstellung erheblich bzw. ist ein nachträglicher Abgleich nicht mehr möglich.

Weiterhin ist es bekannt, zum nachträglichen Abgleich des Temperaturgangs durch eine nachgeschaltete Elektronik sowohl die Differenzspannung der Messbrücke, wie auch die elektrische Spannung über der Messbrücke oder einem Kompensationswiderstand zu messen. Moderne Analog Digital Wandler (wie Cirrus CS5532, Melexis MLX90308) besitzen bereits einen weiteren Messkanal für eine solche Messung.

Ein Nachteil dieses Verfahrens ist der große Eingangsspannungsbereich des AD-Wandlers zwischen dem Potential der Kompensationsmessung und dem Spannungspotential der Brückenspannung. In jedem Fall ist ein qualitativ hochwertiger AD-Wandler mit mindestens zwei Messkanälen erforderlich .

Das Verfahren beinhaltet also einen zusätzlichen Kanal am Analog-Digital-Umsetzer und meist auch eine zusätzliche Leitung zu der Messzelle. Diese mathematisch kompensierende Verfahren werden vielfach aufgrund der zusätzlichen Leitung und des höheren Anspruchs an den AD-Wandler nur selten eingesetzt.

Die EP 1 251 357 A1 zeigt die Bestimmung von Widerständen mittels Messung der Entladezeiten eines Kondensators über dieselben. Hierdurch können bei temperaturabhängigen Widerständen Temperaturmessungen vorgenommen werden, wenn die Temperatur-Widerstandskennlinie bekannt ist, eine Kompensation des Temperaturganges ist aber nicht vorgesehen.

Ausgehend von insbesondere dem eingangs genannten Stand der Technik liegt daher der Erfindung die Aufgabe zugrunde, ein Verfahren und eine Vorrichtung zu schaffen, mit der ein Span-Fehler bei Messbrücken, wie Wheatstonebrücken insbesondere mit Dehnungsmessstreifen, berücksichtigt und kompensiert werden kann. Ein Span-Fehler wird nicht nur durch die Widerstände verursacht, sondern auch von der Wärmeausdehnung und dem Temperaturgang des Elastizitätsmodul der Auflagefläche.

Erfindungsgemäß wird die genannte Aufgabe durch ein Verfahren der eingangs genannten Art gelöst, das die Merkmale des Anspruchs 1 aufweist. Die Erfindung sieht weiterhin zur Lösung der genannten Aufgabe eine Vorrichtung der eingangs genannten Art zur Durchführung des Verfahrens mit den kennzeichnenden Merkmalen des Anspruchs 1 vor.

Soweit Schalter angesprochen sind, handelt es sich um elektronische Schalter. Durch die Erfindung wird in einfacher Weise eine Messung an einer üblichen Messbrücke, wie einer Wheatstone-Brückenschaltung ohne Änderungen an derselben und damit eine Kompensation des Temperaturganges des Spans und des Offsets in einer Nachbehandlung (postprocessing) möglich. Die Temperatur an der Messbrücke kann mit den bereits vorhandenen Widerstandsstreifen erfasst werden und damit kann eine vollständige Temperaturkompensation ohne Eingriff in die Brücke durchgeführt werden, so dass die Messbrücke nach Herstellung ohne mechanischen Eingriff mit einfachen Mitteln vollständig abgeglichen werden kann. Produktions- oder Chargenschwankungen können erfindungsgemäß nachträglich kompensiert werden. Die erfindungsgemäße Vorrichtung lässt sich dabei vollständig in einen integrierten Schaltkreis integrieren, so dass ein externer Aufwand außerhalb eines solchen innerhalb eines Chips realisierten Schaltkreises nicht erforderlich ist.

Abgleichelemente für den Offset entfallen vollständig. Es können insbesondere auch unselektierte Brückenwiderstände zum Einsatz kommen, da der Abgleich des Nullpunktes im Rahmen durch eine verfahrensmäßige Auswertung im Rahmen der Erfindung erfolgen kann, so dass Abgleichbedingungen für die Brückenwiderstände entfallen. Insbesondere kann eine einzelne Brücke vollständig mit einem einzigen Temperaturlauf abgeglichen werden, wobei kein mechanischer Eingriff in die fertig applizierte Brücke notwendig ist.

Brücken einer Produktionscharge können nach Abschluss der Produktion anhand des Temperaturgangs einiger Muster abgeglichen werden. Fertigungsschwankungen einzelner Chargen können so nachträglich und ohne Nachbearbeitung der Brücken ausgeglichen werden.

Weitere Vorteile des erfindungsgemäßen Verfahrens und der erfindungsgemäßen Vorrichtung in produktionstechnischer Hinsicht liegen darin, dass die Ansprüche an die Reproduzierbarkeit der Fertigung reduziert werden können und sich allein durch die geringen Ansprüche an die Widerstände selbst bereits Kostenvorteile durch die Bauteilauswahl ergeben. Der Abgleich einer gesamten Produktion kann erfindungsgemäß nachträglich ohne mechanischen Eingriff in die Messbrücken erfolgen.

Gemäß einer bevorzugten Ausgestaltung des erfindungsgemäßen Verfahrens ist vorgesehen, dass die Kapazität bis zum Erreichen einer Schaltschwelle eines Schwellwertschalters entladen wird.

Gemäß einer bevorzugten Weiterbildung ist vorgesehen, dass die Entladezeiten bzw. Entladezeitanteile der einzelnen Widerstände der Messbrücke an der Kapazität ins Verhältnis gesetzt werden. Das Verhältnis oder die Verstimmung

$$\left(\Delta^R/_R\right)_{\text{kompensiert}} = \frac{t'_1}{t'_2}$$

ist das Ausgangssignal der Messbrücke ohne den Einfluss des Span kompensierenden Serienwiderstands. Falls für die Brückenwiderstände $R_1$ bis $R_4$ einer Messbrücke die Abgleichbedingung $R_1/R_2 = R_3/R_4$ erfüllt ist und die Brückenwiderstände unverstimmt bzw. die Messbrücke nicht belastet ist, ist bei der vorstehenden relativen Verstimmung das thermische Ausgangssignal unterdrückt, wobei eine unvermeidliche Offset-Verschiebung des Nullpunktes keine Rolle spielt, da noch keine Span-Kompensation anliegt.

Zur Span-Kompensation sieht die Erfindung in einer weiteren bevorzugten Ausgestaltung vor, dass das Ausgangssignal der Messbrücke gemäß

$$\left(\frac{\Delta R}{R}\right)_{\text{Span-kompensiert}} = \left(\frac{t'_1}{t'_2} - \frac{t'_3}{t'_4} - TkO\right)\frac{1}{1 + TkS\dfrac{2 \cdot t_k}{t'_1 + t'_2}}$$

bestimmt wird, wobei $t'_1$, $t'_2$, $t'_3$, $t'_4$ die Entladezeiten der Kapazität über die einzelnen Widerstände der Messbrücke, TkO der Offset-Fehler der unverstimmten, unbelasteten Messbrücke, TkS ein Korrekturfaktor für den Span-Fehler der Messbrücke und $t_k$ der Entladezeitanteil ein im Eingangskreis der Messbrückeangeordneten Kompensationswiderstandes ist, wodurch aufgrund eines in der Schaltung vorgesehenen Kompensationswiderstandes $R_k$ nach gegebenenfalls rechnerischer Multiplikation und damit Anpassungen desselben eine korrigierte Kompensation vorgenommen werden kann, wodurch Fehlabgleiche in der Produktion korrigiert bzw. generell die Produktion vereinfacht werden kann, indem man für letzteren Fall nur einen grob angepassten Kompensationswiderstand verwendet und diesen nachträglich rechnerisch bzw. softwaremäßig anpasst. Hierdurch können Produktionskosten praktisch ohne Zusatzaufwand gespart werden.

Die Messung kann mit einem üblicherweise schon vorhandenen Kompensationswiderstand bzw. -messstreifen ohne zusätzlichen Messaufwand im Sensor erfolgen, der zur digitalen Korrektur herangezogen werden kann, wodurch spätere Eingriffe in den Sensor vermeidbar sind. Da der Kompensationswiderstand, wie gesagt, nicht mehr exakt an die Messbrücke angepasst sein muss, können aus Produktions- oder Kostengesichtspunkten auch größere oder kleinere Werte als üblich gewählt werden. Auch muss der Kompensationswiderstand an sich während der Produktion nicht exakt bekannt sein, da der Abgleich des Temperaturganges des Ausgangssignals bei einer nachgeschalteten mathematischen Verarbeitung erfolgt.

Gemäß dem vorstehenden Verfahren kann eine einzelne Brücke vollständig mit einem einzigen Temperaturlauf mittels mathematischer Anpassung der Korrekturfaktoren von Offset- und Span-Fehler abgeglichen werden, ohne dass ein mechanischer Eingriff in die fertig applizierte Brücke notwendig ist.

Gemäß der bevorzugten Weiterbildung der vorgenannten Ausgestaltung der Erfindung ist vorgesehen, dass der Korrekturfaktor für den Span-Fehler der Messbrücke zwischen 3/4 und 1 liegt. Bevorzugte konkrete Werte in Abhängigkeit des genauen Schaltungsaufbaus werden weiter unten angegeben.

Die Erfindung beinhaltet in bevorzugter Ausgestaltung, dass mehrere Entladevorgänge der Kapazität über verschiedene Wege und verschiedene in diesen Wegen vorgesehene Widerstände bzw. Widerstandskombinationen (Reihen- und/oder Parallelschaltung) vorgenommen werden, wobei dann in bevorzugter Ausgestaltung vorgesehen ist, dass die Entladezeitanteile der einzelnen Widerstände der Messbrücke durch Subtraktion von Entladezeitanteilen von Kompensationswiderständen und eventuellen Widerständen von Analogschaltern, über die die Entladungen bei Messung von Entladezeiten über die Widerstände der Messbrücke miterfolgt sind, bestimmt werden.

In einer ersten konkreten Ausgestaltung erfolgt die Messung von Entladezeiten derart, dass Entladezeiten über jeweils einen Widerstand der Messbrücke und mit diesem in Reihe stehenden Kompensationswiderstand und die Entladezeiten über jeweils einen anderen Widerstand der Messbrücke bestimmt werden, wobei der Zeitanteil des Kompensationswiderstandes gemäß

$$t_k = R_k * C = \tfrac{1}{2}\left(\left(t_1 + t_2\right) - \left(t_3 + t_4\right)\right)$$

bestimmt wird. In einer ersten alternativen Weiterbildung dieses Verfahrens ist vorgesehen, dass die Kapazität zusätzlich über den Kompensationswiderstand und die mit diesem in Reihe, zueinander parallel geschalteten Widerstände der Messbrücke entladen wird, wobei die Entladezeit

$$t_{12} = \left( \frac{R_1 R_2}{R_1 + R_2} + R_k \right) \cdot C$$

über den Kompensationswiderstand und die mit diesem in Reihe, zueinander parallel geschalteten Widerstände der Messbrücke gemessen wird. Alternativ hierzu kann erfindungsgemäß vorgesehen sein, dass der Zeitanteil des Kompensationswiderstandes gemäß

$$t_k = R_k C = 2 \cdot \left( t_{12} - \frac{t_1 t_2}{t_1 + t_2} \right)$$

bestimmt wird.

Gemäß einer anderen erfindungsgemäßen Ausgestaltung der Erfindung ist vorgesehen, dass eine zwischen Eingangskreis und Widerstandsschaltkreis der Messbrücke angeordnete Kapazität nacheinander über einen Widerstand der Messbrücke und den zu diesem parallel liegenden anderen Widerständen der Messbrücke und einen mit der Messbrücke in Reihe liegenden Analogschalter entladen wird, wobei insbesondere die Entladezeiten gemäß

$$t_1 = (R'_1 + R_x + R_k) * C \qquad \text{Schalter } S_x \text{ und } S_{1'} \text{ geschlossen}$$

$$t_2 = (R'_2 + R_x + R_k) * C \qquad \text{Schalter } S_x \text{ und } S_{2'} \text{ geschlossen}$$

$$t_3 = (R'_3 + R_y \quad) * C \qquad \text{Schalter } S_y \text{ und } S_{1'} \text{ geschlossen}$$

$$t_4 = (R'_4 + R_y \quad) * C \qquad \text{Schalter } S_y \text{ und } S_{2'} \text{ geschlossen}$$

bestimmt werden, wobei

$$R'_1 = \frac{R_1 \cdot (R_2 + R_3 + R_4)}{R_1 + R_2 + R_3 + R_4} \qquad\qquad R'_2 = \frac{R_2 \cdot (R_1 + R_3 + R_4)}{R_1 + R_2 + R_3 + R_4}$$

$$R'_3 = \frac{R_3 \cdot (R_1 + R_2 + R_4)}{R_1 + R_2 + R_3 + R_4} \qquad\qquad R'_4 = \frac{R_4 \cdot (R_1 + R_2 + R_3)}{R_1 + R_2 + R_3 + R_4}$$

ist.

Eine Weiterbildung der vorgenannten Ausgestaltung sieht vor, dass die Größe der Widerstände der Messbrücke gewählt wird zu $R_1 + R_2 = R_3 + R_4$, wobei die Widerstände $R_1$, $R_2$ den einen Widerstandsschaltkreis und die Widerstände $R_3$, $R_4$ den hierzu parallel angeordneten Widerstandsschaltkreis der Messbrücke bilden und dass der Zeitanteil des Kompensationswiderstandes gemäß

$$t_k = R_k * C = \tfrac{1}{2} ((t_1 + t_2) - (t_3 + t_4))$$

bestimmt wird. Alternativ hierzu kann vorgesehen sein, dass die Kapazität zusätzlich über den Kompensationswiderstand, einen Analogschalter mit einem Einschaltwiderstand) und die mit diesen in Reihe, zueinander parallel geschalteten Widerstände $R_1$, $R_2$ entladen wird, wobei die Entladezeit gemäß

$$t_{12} = \left( \frac{R_1 R_2}{R_1 + R_2} + R_k + R_x \right) \cdot C$$

bestimmt wird und weiterhin der Zeitanteil des Kompensationswiderstandes gemäß

$$t_k = R_k C = 3 \cdot \left( t_{12} - \frac{(5t_1 - t_2)(5t_2 - t_1)}{12 \cdot (t_1 + t_2)} \right) - t_x$$

bestimmt wird.

Zur Bestimmung der Entladezeitanteile der inneren Widerstände mindestens eines Analogschalters kann zunächst in einer ersten bevorzugten Weiterbildung des erfindungsgemäßen Verfahrens vorgesehen sein, dass die Kapazität über mindestens einen Analogschalter mit einem Einschaltwiderstand und nacheinander mit einem von zwei mit diesem in Reihe geschalteten Entladewiderstand entladen wird, wobei insbesondere die Entladezeiten

$$t_{g1} \;\; = \;\; ( \; R_{g1} \; + \; R_x \; ) \;\; * \; C$$

$$t_{g2} \;\; = \;\; ( \; R_{g2} \; + \; R_x \; ) \;\; * \; C$$

gemessen werden und die Entladezeit der Kapazität über einen Analogschalter mit einem Einschaltwiderstand und zwei mit diesem in Reihe und parallel zueinander geschaltete Entladewiderstände entladen wird.

In Weiterbildung ist vorgesehen, dass die Entladezeit der Kapazität über mindestens einen Analogschalter mit einem Einschaltwiderstand und zwei mit diesem in Reihe, parallel zueinander geschaltete Entladewiderstände gemäß

$$t_{g1-g2} = \left( \frac{R_{g1} R_{g2}}{R_{g1} + R_{g2}} + R_x \right) \cdot C$$

gemessen werden, wobei der Entladezeitanteil über den Einschaltwiderstand eines Analogschalters gemäß

$$t_x = R_x C = 2 \cdot \left( t_{g1-g2} - \frac{t_{g1} t_{g2}}{t_{g1} + t_{g2}} \right)$$

bestimmt wird. Der so bestimmte Entladezeitanteil für den Einschaltwiderstand eines ersten Analogschalters reicht grundsätzlich zur weiteren Bestimmung und insbesondere zur Kompensation in der oben genannten Weise aus.

Alternativ kann zusätzlich der Entladezeitanteil des Einschaltwiderstandes eines weiteren Analogschalters bestimmt werden, wobei zunächst die Kapazität über einen Analogschalter mit einem Einschaltwiderstand sowie in Reihe mit diesem, parallel zueinander angeordneten Widerständen $R_3$, $R_4$ der Messbrücke gemessen wird und weiterhin die Entladezeit über die Kapazität über einen Analogschalter mit einem Einschaltwiderstand sowie in Reihe mit diesem, parallel zueinander angeordneten Widerständen $R_3$, $R_4$ der Messbrücke gemäß

$$t_{34} = \left( \frac{R_3 R_4}{R_3 + R_4} + R_y \right) \cdot C$$

gemessen wird sowie insbesondere der Entladezeitanteil des Einschaltwiderstandes des Analogschalters gemäß

$$t_y = R_y C = 3 \cdot \left( t_{34} - \frac{(5t_3 - t_4)(5t_4 - t_3)}{12 \cdot (t_3 + t_4)} \right)$$

bestimmt wird.

Die erfindungsgemäße Vorrichtung ist zur Durchführung der letztgenannten Verfahrensausbildungen in bevorzugter Weise derart ausgebildet, dass im Eingangskreis zwischen einer Spannungsquelle und der Messbrücke jeweils ein Analogschalter angeordnet ist, wobei vorzugsweise mindestens ein Analogschalter in Reihe mit Entladewiderständen und Entladeschaltern liegt.

Während weiterhin grundsätzlich vorgesehen sein kann, dass mindestens ein Analogschalter in Reihe mit zwei parallel zueinander angeordneten Entladewiderständen liegt, denen jeweils ein Schalter in Reihe zugeordnet ist, sieht eine bevorzugte Ausgestaltung vor, dass jeder der Messbrücke über einen eigenen zugeordneten, in Reihe geschalteten Schalter mit dem zugehörigen Zweig des Widerstandsschaltkreises verbunden ist.

Weiterbildungen der erfindungsgemäßen Vorrichtung zeichnen sich durch eine im Eingangskreis der Messbrücke angeordnete schaltbare Spannungsquelle und/oder durch einen der Kapazität zugeordneten Schwellwertschalter aus.

Weitere Vorteile und Merkmale der Erfindung ergeben sich aus den Ansprüchen und aus der nachfolgenden Beschreibung, in der Ausführungsbeispiele der Erfindung unter Bezugnahme auf die Zeichnungen im Einzelnen erläutert sind. Dabei zeigt:

Fig. 1a    eine erste Ausführungsform einer erfindungsgemäßen Vorrichtung zur Durchführung des erfindungsgemäßen Verfahrens zur Temperaturkompensation einer Wheatstonebrücke;

Fig. 1b    die Ausgestaltung der Vorrichtung der Fig. 1a in anderer konstruktiver Ausführung;

Fig. 2    eine andere Ausgestaltung der erfindungsgemäßen Vorrichtung zur Temperaturkompensation; und

Fig. 3    eine weitere Ausgestaltung der erfindungsgemäßen Vorrichtung zur Temperaturkompensation.

Die erfindungsgemäße Vorrichtung zur Temperaturkompensation 1 einer Widerstandsbrücke 2 in Form einer Wheatstonebrücke weist zunächst eine solche Wheatstonebrücke 2 als Parallelschaltung zweier Widerstandsschaltkreis 3, 4 mit vier Widerständen $R_1$, $R_2$, $R_3$, $R_4$ auf, wobei die Widerstände $R_1$, $R_3$ den ersten Widerstandsschaltkreis 3 und die Widerstände $R_2$, $R_4$ den zweiten Widerstandsschaltkreis 4 bilden, ein Eingangsspannungskreis 5 zwischen den Widerständen $R_1$ und $R_2$ bzw. den Widerständen $R_3$ und $R_4$, der Widerstandsschaltkreis-Zweig 6 zwischen den Widerständen $R_1$ und $R_3$ einerseits sowie andererseits den Widerständen $R_2$ und $R_4$ angreift.

Die Widerstände $R_1$ bis $R_4$ können beispielsweise Dehnungsmessstreifen einer entsprechenden Messbrücke sein.

Es ist eine Verarbeitungseinrichtung V, vorzugsweise in Form eines Computers, zur Vornahme der erforderlichen Berechnungen und Anwendungen vorgesehen.

Am Eingangszweig 5 liegen eine schaltbare Spannungsquelle 7 und ein Schwellwertschalter 8 an. Weiterhin befindet sich im Eingangszweig 5.1 des Eingangskreises 5 ein Kompensationswiderstand $R_k$. Jedem Widerstand $R_1$ bis $R_4$ der Wheatstonebrücke 2 ist ein Schalter $S_1$ bis $S_4$ zum Widerstandsschaltkreis-Zweig 6 zugeordnet. Zwischen dem Ausgangszweig 5.2 des Eingangskreises 5 und dem Widerstandsschaltkreis-Zweig 6 ist eine Kapazität C in Form eines Kondensators vorgesehen. Der Widerstandsschaltkreis-Zweig 6 ist bei E geerdet.

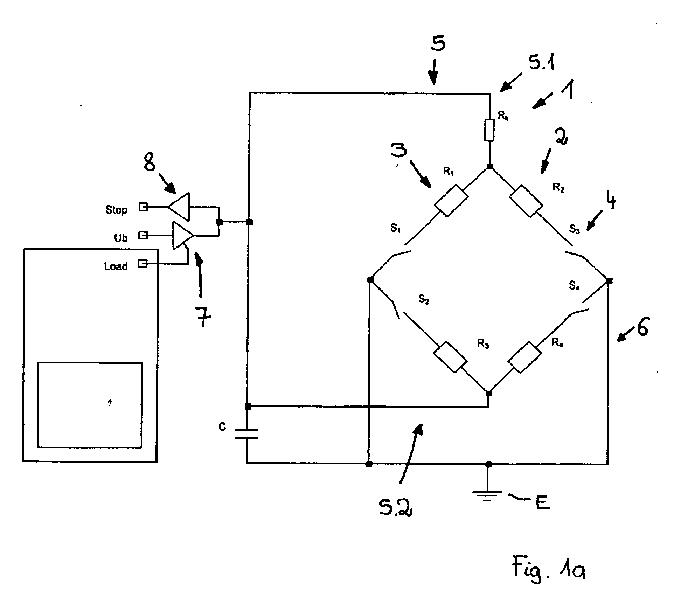

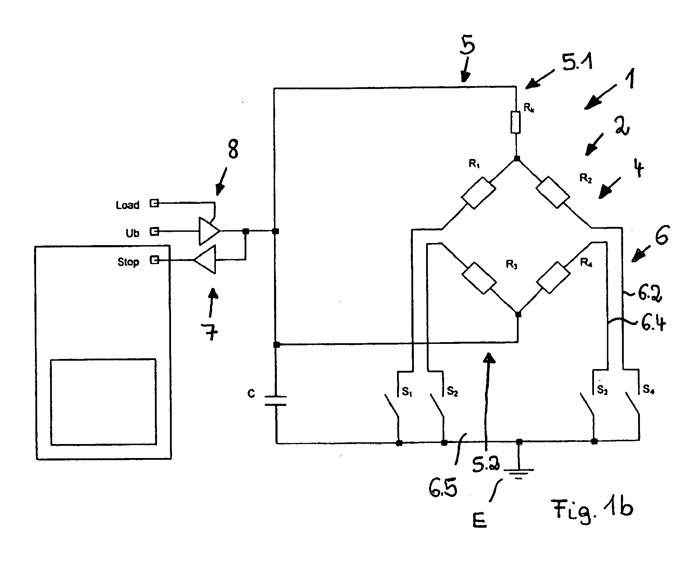

Während bei der Fig. 1a die Schalter $S_1$ bis $S_4$ in der Wheatstonebrücke integriert sind, zeigt die Fig. 1b eine konstruktive Ausführung, bei der die Verbindungsstellen der Widerstände $R_1$, $R_3$ einerseits sowie der Widerstände $R_2$, $R_4$ andererseits an den Widerstandsschaltkreisabzweigungen zunächst aufgetrennt, separat als Leitungen 6.1, 6.2, 6.3, 6.4 aus der Wheatstonebrücke bzw. diesen beinhaltenden Chip herausgeführt und die Schalter $S_1$ bis $S_4$ es außerhalb des Chips der Wheatstonebrücke zur geerdeten Leitung 6.5 hin verbunden sind.

Letzteres hat den Vorteil, dass die Auftrennung in vielen Fällen noch an der applizierten Wheatstonebrücke erfolgen kann, wenn die Verbindungen zwischen den Widerständen $R_1$ und $R_2$ einerseits sowie $R_3$ und $R_4$ frei zugänglich sind. Ansonsten ist die neue Verschaltung, gegebenenfalls auch in der Ausführungsform der Fig. 1a, vor dem Verguss der Messbrücken herzustellen. In jedem Falle ändert sich nur die Verschaltung der applizierten Messbrücke, die Position auf dem Werkstück bleibt unverändert.

Bei der erfindungsgemäßen Vorrichtung der Fig. 1a und 1b wird zur Durchführung des erfindungsgemäßen Verfahrens der Kondensator C zunächst bei geöffneten Schaltern $S_1$ bis $S_4$ jeweils durch die Spannungsquelle 6 aufgeladen. Nach jeder Aufladung wird der Kondensator mittels der Schalter $S_1$ bis $S_4$ nacheinander über die Widerstände $R_1$ bis $R_4$ bis zur Schaltschwelle des Schwellwertschalters 7 entladen. Bei der Entladung über die Widerstände $R_1$ und $R_2$ liegt zusätzlich der Kompensationswiderstand $R_k$ in Reihe.

Die gemessenen Entladezeiten sind dann:

$$
\begin{aligned}
t_1 &= (R_1 + R_k) \quad * \ C \\
t_2 &= (R_2 + R_k) \quad * \ C \\
t_3 &= R_3 \qquad\qquad * \ C \\
t_4 &= R_4 \qquad\qquad * \ C
\end{aligned}
$$

Wenn sich die Auswertung auf die gemessenen Zeiten $t_1$ und $t_2$ beschränkt, ergibt sich für den Sonderfall $R_1=R_4$ und $R_2=R_3$, dass der Temperaturgang des Ergebnisses in identischer Art und Weise zu einer herkömmlichen Wheatstonebrücke kompensiert wird.

In der messtechnischen Praxis mit Wheatstonebrücken müssen für das Ergebnis alle vier Zeitmessungen $t_1$ bis $t_4$ einfließen. Da in den Messungen $t_3$ und $t_4$ die Kompensation des Temperaturgangs durch $R_k$ fehlt, ist eine weitergehende Temperaturkompensation erforderlich.

Da der Kompensationswiderstand $R_k$ prinzipiell zur Temperaturkompensation geeignet ist, wird der Zeitanteil $R_kC$, welcher den Kompensationswiderstand bei der Entladung der Widerstände $R_1$ und $R_2$ verursacht, getrennt erfasst und für eine mathematische Kompensation genutzt.

Die Verfahren zur Ermittlung von $R_kC$ werden im Folgenden zur Berechnung des thermisch kompensierten Ergebnisses weiter unten und durch Darstellung der anderen Vorrichtungen und Messverfahren beschrieben.

**Bestimmung des Kompensationswiderstandes ohne Zusatzmessung**

In den Messungen $t_1$ und $t_2$ ist der Zeitanteil $t_k=R_kC$ enthalten, der den Kompensationswiderstand $R_k$ erzeugt.

Üblicherweise haben die Widerstände einer Messbrücke den gleichen Nennwert, z.B. 350 Ohm oder 1k Ohm, so dass mit ausreichender Genauigkeit angenommen werden kann:

$$
R_1 + R_2 = R_3 + R_4
$$

Bei der Applikation von Dehnungsmessstreifen als Wheatstonebrücke ist diese Beziehung auch bei anliegendem Messsignal in den meisten Fällen sichergestellt, da sich die Widerstände paarweise verändern. Beispielsweise werden $R_1$ und $R_4$ gemeinsam gedehnt oder $R_2$ und $R_3$ gemeinsam gestaucht.

Mit dieser Übereinstimmung kann mit den vorhandenen vier Messungen $t_1$, $t_2$, $t_3$, $t_4$ direkt der Zeitanteil $t_k$ des Kompensationswiderstands mit einer einfachen Differenzbildung berechet werden.

$$
t_k = R_k * C = \tfrac{1}{2}\,((t_1 + t_2) - (t_3 + t_4))
$$

Hierdurch sind durch einfache Berechnungen keine weiteren Schaltungsmaßnahmen in der Brücke oder der Elektronik und keine Zusatzmessungen erforderlich.

**Bestimmung des Kompensationswiderstandes mit Zusatzmessung**

Die Laufzeit eines RC-Glieds wird aus dem Kompensationswiderstand $R_k$ und dem Entladekondensator C bestimmt.

Alternativ zur vorstehenden Bestimmung von $t_k$ wird eine zusätzliche Entladung durchgeführt, indem der geladene Kondensator über die elektronischen Schalter $S_1$ und $S_2$ (beide gleichzeitig geschlossen) gleichzeitig entladen wird. Als Entladungswiderstand resultiert die Parallelschaltung der Widerstände $R_1$ und $R_2$

$$t_{12} = \left( \frac{R_1 R_2}{R_1 + R_2} + R_k \right) \cdot C$$

In allen drei Messungen für $t_1$, $t_2$ und $t_{12}$ ist der Zeitanteil $t_k=R_kC$ enthalten und kann ohne Zusatzannahmen berechnet werden

$$t_k = R_k C = 2 \cdot \left( t_{12} - \frac{t_1 t_2}{t_1 + t_2} \right)$$

Die Formel für $t_k$ ist eine Näherung der exakten Lösung, die für die üblichen Erfordernisse völlig ausreicht.

**Direkter Anschluss einer Wheatstonebrücke**

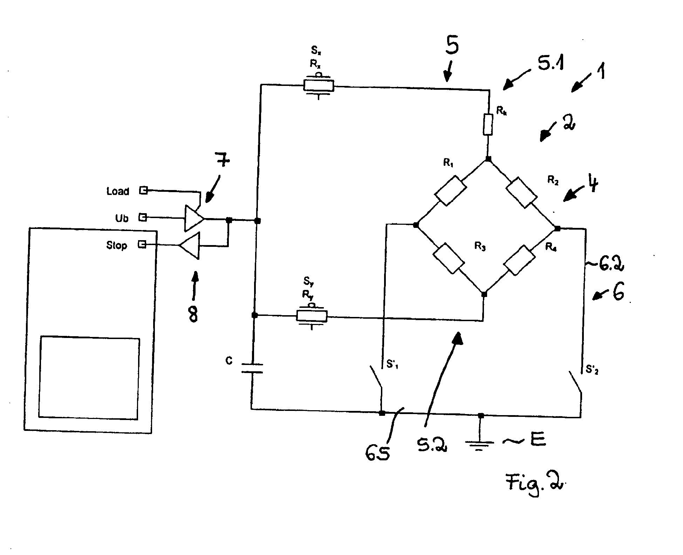

Die allermeisten heutigen Dehnungsmessstreifen-Anwendungen nutzen die Wheatstonebrücke. Daher ist ein Verfahren von Vorteil, das solche bereits vorhandenen Sensoren ohne jede Änderung am Sensor auswerten kann. Dies ist in Fig. 2 dargestellt. Mit zwei zusätzlichen, handelsüblichen Analogschaltern $S_x$ und $S_y$ im Eingangszweig 5.1 und Ausgangszweig 5.2 des Eingangskreises 5 ist das auch im Rahmen der Erfindung möglich. Die Schalter $S_x$ und $S_y$ haben (innere) Widerstände $R_x$ und $R_y$. Weiter sind in den Zweigen 6.1, 6.2 des Widerstandsschaltkreises 6 die Schalter $S'_1$ und $S'_2$ angeordnet.

Da der Einschaltwiderstand $R_x$ und $R_y$ bei der Entladung in Reihe zum Messwiderstand liegt, sollte der Einschaltwiderstand $R_x$ und $R_y$ der Schalter $S_x$ und $S_y$ kleiner gegenüber den Widerständen der Messbrücke 2 sein, vorzugsweise kleiner als 10 Ohm, um die Messung nicht zu sehr zu verfälschen.

Weiter unten wird ein Verfahren zur vollständigen Kompensation des Einschaltwiderstands aufgezeigt.

Da die beiden Schalter $S_x$ und $S_y$ vorzugsweise in einem einzigen Chip integriert sind, sind die Einschaltwiderstände über die Temperatur und die Betriebsspannung sehr gut im Gleichlauf und es gilt mit ausreichender Genauigkeit im gesamten Temperaturbereich die Beziehung $R_x=R_y=R_{xy}$ bei Wahl der gleichen Größe von $R_x$ und $R_y$.

Für eine Entladung werden immer einer der Schalter $S_x$ oder $S_y$ und einer der Schalter $S'_1$ oder $S'_2$ geschlossen.

Wenn z.B. Schalter $S_x$ und $S_1$ geschlossen sind, liegt parallel zum Widerstand $R_1$ die Reihenschaltung von $R_2$, $R_3$ und $R_4$, so dass sich ein neuer resultierender Widerstand $R'_1$ ergibt.

Zur Vereinheitlichung mit dem oben beschriebenen Standardverfahren führt man deshalb sinnvoller Weise vier neue Widerstände ein, die sich durch die unvermeidliche Parallel- und Reihenschaltung der Wheatstone-Anordnung ergeben.

$$R'_1 = \frac{R_1 \cdot (R_2 + R_3 + R_4)}{R_1 + R_2 + R_3 + R_4} \qquad R'_2 = \frac{R_2 \cdot (R_1 + R_3 + R_4)}{R_1 + R_2 + R_3 + R_4}$$

$$R'_3 = \frac{R_3 \cdot (R_1 + R_2 + R_4)}{R_1 + R_2 + R_3 + R_4} \qquad R'_4 = \frac{R_4 \cdot (R_1 + R_2 + R_3)}{R_1 + R_2 + R_3 + R_4}$$

Nach dem gleichen Messablauf wie oben, werden vier Zeiten gemessen:

```
t₁ = (R'₁ + Rₓ + Rₖ) *C   Schalter Sₓ und S₁· geschlossen

t₂ = (R'₂ + Rₓ + Rₖ) *C   Schalter Sₓ und S₂· geschlossen
```

$$t_3 = (R'_3 + R_y \quad ) *C \quad \text{Schalter } S_y \text{ und } S_{1'} \text{ geschlossen}$$

$$t_4 = (R'_4 + R_y \quad ) *C \quad \text{Schalter } S_y \text{ und } S_{2'} \text{ geschlossen}$$

Bei der Messung ist den Messwiderständen $R'_1$ und $R'_2$ zusätzlich der Einschaltwiderstand $R_x$ und der Kompensationswiderstand $R_k$ in Reihe geschaltet. Den Messwiderständen $R'_3$ und $R'_4$ ist entsprechend nur der Einschaltwiderstand $R_y$ zugeschaltet. Aus den ermittelten Zeiten $t_1$ bis $t_4$ können die thermisch unkompensierten Ergebnisse bestimmt werden.

Durch die jeweilige Parallelschaltung der drei restlichen Widerstände der Wheatstonebrücke zum eigentlichen gerade gemessenen Messwiderstand sinkt der neue Grundwiderstand auf 3/4 des Nennwerts der eingesetzten Widerstände. Der messbare Hub der Widerstandsänderung relativ zum Grundwiderstand liegt dagegen bei nur 2/3 des Hubs der eingesetzten Widerstände, da die drei parallel geschalteten, eigentlich unerwünschten und parasitären Widerstände ebenfalls mit der Dehnung ihren Widerstandswert verändern.

Ein besonderer Vorteil des vorstehenden Verfahrens ist die weitgehende Unterdrückung der Streukapazitäten der Zuleitungen. Bei den vier Zeitmessungen ist der Schalter einer Zuleitungskapazität zweimal geschlossenen und zweimal offen. Beispielsweise ist der Schalter $S_x$ für die Zeitmessung $t_1$ und $t_2$ geschlossen und die Zuleitungskapazität gegen Masse geschaltet. Der Störeinfluss wirkt also in gleicher Art und Weise auf zwei Zeitmessungen, die später ins Verhältnis gesetzt werden. Dadurch heben sich die Messwertabweichung durch die Zuleitungskapazität ohne weitere Maßnahmen gegenseitig auf.

Zur vollständigen Temperaturkompensation der Zeitmessungen muss auch bei der Wheatstonebrücke der Wert des Kompensationswiderstandes direkt gemessen werden. Auch hier ist der Ablauf grundsätzlich identisch zum unter Bezug auf die Fig. 1a, 1b beschriebenen Verfahren. Aufgrund der Parallelschaltung haben die Widerstände $R'_1...R'_4$ nicht mehr die gleichen Werte und Dehnungen wie $R_1...R_4$. Damit hat der Kompensationswiderstand der herkömmlichen Wheatstonebrücke nicht mehr automatisch die passende Größe für das hier beschriebene Verfahren. Da die Messung des Kompensationswiderstands ein integraler Bestandteil des Verfahrens ist, muss die Anpassung hier aber nicht physikalisch durch Änderung des Widerstandswertes erfolgen, sondern kann per nachträglicher Berechnung als mathematischer Korrekturfaktor und dadurch äußerst preisgünstig und genau erfolgen. So können handelsübliche Wheatstonebrücken mit voller Temperaturkompensation ohne Änderungen an das erfindungsgemäße Verfahren angeschlossen werden.

Die Verfahren zur Ermittlung von $R_kC$ werden im Folgenden beschrieben. Anschließend wird ein Verfahren zur Messung und Kompensation der Schalterwiderstände $R_x$ und $R_y$ gezeigt. Danach wird dann die schon erwähnte Bestimmung des thermisch kompensierten Ergebnis erläutert.

**Bestimmung des Kompensationswiderstandes ohne Zusatzmessung**

Für die Bestimmung des Zeitanteils $R_kC$ des Kompensationswiderstands $R_x$ aus den vier Zeitmessungen $t_1...t_4$ ergeben sich auch für die Wheatstonebrücke die gleichen Zusammenhänge und Berechnungsmethoden wie unter Bezug auf Fig. 1a, 1b erläutert. Unter der Annahme, dass die Einschaltwiderstände $R_x$ und $R_y$ ausreichend gut im Gleichlauf sind, entfällt ihr Wert bei der Differenzbildung. Mit der Annahme:

$$R_1 + R_2 = R_3 + R_4$$

kann daher der Zeitanteil bestimmt werden

$$t_k = R_k * C = \tfrac{1}{2}((t_1 + t_2) - (t_3 + t_4))$$

**Bestimmung des Kompensationswiderstands/Temperaturmessung mit Zusatzmessung**

Es wird wiederum der Zeitanteil $R_kC$ aus dem Kompensationswiderstand $R_k$, dem Einschaltwiderstand $R_x$ und Entladekondensator C bestimmt.

Es wird eine weitere Entladung durchgeführt, indem der geladene Kondensator über die Schalter $S_1$, $S_2$ und

$S_x$ gleichzeitig entladen wird. Als Entladewiderstand resultiert, wie schon bei obiger Standardschaltung der Fig. 1a, 1b die Parallelschaltung der Widerstände $R_1$ und $R_2$, die gemeinsam sowohl mit dem Kompensationswiderstand $R_k$ als auch dem Schalterwiderstand $R_x$ in Reihe geschaltet sind:

$$t_{12} = \left( \frac{R_1 R_2}{R_1 + R_2} + R_k + R_x \right) \cdot C$$

Die beiden Widerstände $R_3$ und $R_4$ sind für die Entladung weitgehend wirkungslos, da sie an beiden Seiten auf annähernd dem gleichen Potential über den Schaltern $S'_1$ und $S'_2$ liegen.

In allen drei Messungen ist der Zeitanteil $t_k = R_k C$ enthalten und kann bestimmt werden

$$t_k = R_k C = 3 \cdot \left( t_{12} - \frac{(5t_1 - t_2)(5t_2 - t_1)}{12 \cdot (t_1 + t_2)} \right) - t_x$$

Die Formel für $t_k$ ist eine Näherung der exakten Lösung, die für die üblichen Erfordernisse völlig ausreicht.

Die Messung des Zeitanteils der Einschaltwiderstände $R_x$, $R_y$ wird im Folgendem erläutert.

**Messung der Einschaltwiderstände der Analogschalter**

Zur Messung der Einschaltwiderstände $R_x$ und $R_y$ der Analogschalter $S_x$ und $S_y$ sind in Reihe zum Analogschalter $S_x$ und parallel zueinander Entladewiderstände $R_{g1}$, $R_{g2}$ angeordnet und ist jeweils in Reihe ein elektronischer Schalter $S_{g1}$, $S_{g2}$ zugeordnet. Entsprechendes kann für den Analogschalter $S_y$ mit den Entladewiderständen $R_{g3}$, $R_{g4}$ und den Schaltern $S_{g3}$, $S_{g4}$ gelten, jeweils in Reihe zu diesem Entladewiderstand. Die Widerstände $R_x$ und $R_y$ und deren Temperaturgang gehen additiv mit dem Zeitanteil $R_x C$ in die gemessenen Zeiten $t_1$ und $t_4$ und mit dem Zeitanteil $R_y C$ in die Zeiten $t_2$, $t_3$ mit ein. Als Folge hat der Schalterwiderstand eine geringfügige Verminderung des Spans und insbesondere einen zusätzlichen Temperaturgang (und Betriebsspannungsabhängigkeit) der Messergebnisse.

Wenn die beiden Analogschalter als Doppelschalter in einem Gehäuse liegen, ist der Temperaturgang beider Schalter sehr gut im Gleichlauf (Abweichung < 5%). Es reicht deshalb in den meisten Fällen durchaus aus, mit der Messung eines Schalterwiderstands beide Schalter zu kompensieren. Es gilt dann:

$$R_{xy} = R_x = R_y$$

Für diesen Fall ist es nicht notwendig vier Entladewiderstände für die Messung der zwei Analogschalter anzuschließen, sondern es reichen zwei Widerstände, z.B $R_{g1}$, $R_{g2}$. Das Ergebnis wird dann auch für den nicht gemessenen Analogschalter genutzt. Aus diesem Grunde ist die Verbindung von $S_y$ zu den Entladewiderständen $R_{g3}$, $R_{g4}$ gestrichelt dargestellt, da sie fakultativ und nicht zwingend ist.

Für die Kompensation der Schalterwiderstände sind verschiedene Varianten möglich. Es wird wieder, wie schon beim Kompensationswiderstand, der Laufzeitanteil $R_x C$ aus dem Schalterwiderstand $R_x$ und dem Entladekondensator C bestimmt.

**Durchführung der Messung mit Zusatzwiderständen**

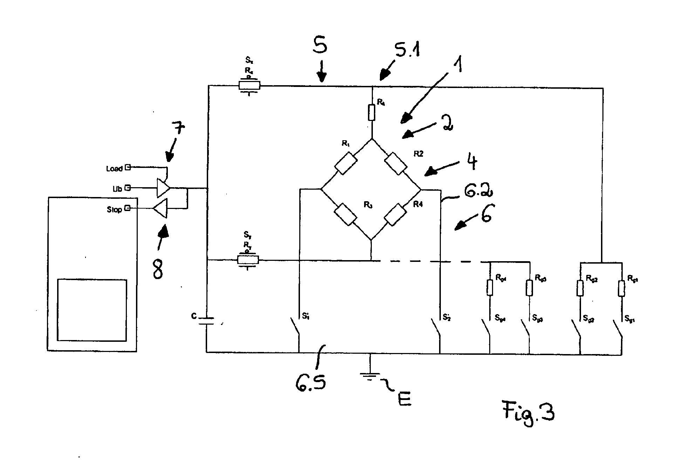

Wie in Fig. 3 gezeigt, können ohne Änderung der Wheatstonebrücke können bereits auf der Elektronik am Anschlusspunkt von $S_x$ bzw. $R_x$ der Messbrücke zwei Zusatzwiderstände $R_{g1}$, $R_{g2}$ angebracht werden. Damit können drei Zeitmessungen ausgeführt werden:

$$t_{g1} = (R_{g1} + R_x) * C$$

$$t_{g2} = (R_{g2} + R_x) * C$$

$$t_{g1-g2} = \left( \frac{R_{g1} R_{g2}}{R_{g1} + R_{g2}} + R_x \right) \cdot C$$

In allen drei Messungen ist der Zeitanteil $t_x = R_x C$ enthalten und kann berechnet werden. Die Formel ist eine Näherung der exakten Lösung , deren Genauigkeit vollständig ausreichend ist:

$$t_x = R_x C = 2 \cdot \left( t_{g1-g2} - \frac{t_{g1} t_{g2}}{t_{g1} + t_{g2}} \right)$$

Optional kann, wie im obigen Bild gezeigt, auch der Einschaltwiderstand $R_y$ mit zwei Zusatzwiderständen direkt gemessen werden. Der Ablauf der Messung und die Auswertung ist identisch. Mit dem Zeitanteil $R_y C$ können die Auswertungen verfeinert werden, so dass man sich auf das Gleichlaufverhalten der Einschaltwiderstände $R_x$ und $R_y$ nicht mehr verlassen muss. Die Vorteile sind jedoch so gering, so dass, wie gesagt, kein Gebrauch davon gemacht werden muss, dies aber fakultativ möglich ist.

**Durchführung der Messung ohne Zusatzwiderstände**

Alternativ kann der Laufzeitanteil $t_y$ und die Widerstände $R_{g3}$ und $R_{g4}$ bestimmt werden.
Der Ablauf entspricht vollständig dem unter Bezug auf die Fig. 1a, 1b beschriebenen. Die zusätzliche Entladung wird hier über Schalter S', S' und $S_y$ durchgeführt. Da in dieser Entladungsanordnung kein Kompensationswiderstand in Reihe liegt, wird nur der Zeitanteil $R_y C$ des Schalters $S_y$ gemessen.
Die zusätzliche Zeitmessung ist dann

$$t_{34} = \left( \frac{R_3 R_4}{R_3 + R_4} + R_y \right) \cdot C$$

Mit den Messungen $t_3$, $t_4$ und $t_{34}$ kann mit den unter Bezug auf Fig. 1a, 1b genannten Einschränkungen der Zeitanteil $t_y = R_y C$ bestimmt werden:

$$t_y = R_y C = 3 \cdot \left( t_{34} - \frac{(5t_3 - t_4)(5t_4 - t_3)}{12 \cdot (t_3 + t_4)} \right)$$

Die Formel für $t_y$ ist eine Näherung der exakten Lösung, die für die üblichen Erfordernisse völlig ausreicht. Mit dieser Variante muss allerdings von dem guten Gleichlaufeigenschalten von $R_x = R_y = R_{xy}$ Gebrauch gemacht werden.

**Abgleich des Temperaturgangs mit mathematischen Methoden**

Im Folgenden werden die Ausgestaltungen der in Verbindung mit den Fig. 1a, 1b einerseits und der Fig. 2, 3 andererseits beschriebenen Verfahren gemeinsam behandelt bzw. weitergeführt, da es nur geringe Unterschiede in der Auswertung gibt. Zuerst wird gezeigt, wie die Zeitmessungen von dem Einfluss der Zusatzwiderstände ($R_k$, $R_x$, $R_y$) befreit werden. Anschließend wird das Kompensationsverfahren für den Abgleich des thermischen Span- und Offsetfehlers vorgestellt.
In den vier Zeitmessungen der Brückenwiderstände sind die Zeitanteile des Kompensationswiderstandes $R_k$ und der Einschaltwiderstände $R_x$ und $R_y$ enthalten. Im Fall der Wheatstonebrücke mit den Schaltern $S_1$ bis $S_4$ gemäß der Figuren 1a und 1b wird $t_x$ und $t_y$ ersetzt.

$$t'_1 = t_1 - t_x - t_k$$

$$t'_2 = t_2 - t_x - t_k$$

$$t'_3 = t_3 - t_y$$

$$t'_4 = t_4 - t_y$$

Dabei gilt für die Ausgestaltung der Fig. 1a, 1b: $t_x=0$, $t_y=0$ und für die Fig. 2, 3; $t_{x,y}$ wie unter Bezug auf diese Figuren beschrieben.

Mit der einfachen Subtraktion des vorher bestimmten Zeitanteils $t_k$, $t_x$, wie unter Bezug sowohl auf die Fig. 1a, 1b als auch die Fig. 2, 3 und $t_y$, wie unter Bezug auf die Fig. 2, 3 beschrieben, ist der Einfluss der Widerstände auf die Messzeiten der Brückenwiderstände vollständig eliminiert. Die Wirksamkeit dieses Vorgehens ist durch Untersuchungen hinreichend bestätigt worden. Die relative Verstimmung $\Delta R/R$ der Brückenwiderstände $R_1$ bis $R_4$ wird nun durch die Verhältnisbildung der kompensierten Zeiten und anschließender Subtraktion berechnet.

$$\left(\frac{\Delta R}{R}\right)_{kompensiert} = \frac{t'_1}{t'_2} - \frac{t'_3}{t'_4}$$

Die relative Verstimmung $(\Delta R/R)$ kompensiert ist vollständig von dem Einfluss des Kompensationswiderstands $R_k$ und den Einschaltwiderständen $R_x$ und $R_y$ auf die Span und den Temperaturgang befreit. Das Verhältnis $(\Delta R/R)$ kompensiert beinhaltet somit den Hub und den Temperaturgang der Wheatstonebrücke ohne applizierten Kompensationswiderstand $R_k$. Im Folgenden wird die Modifikation der Formel mit $t_k$ gezeigt, um die vollständige Kompensation des Temperaturgangs der Wheat stonebrücke zu erreichen.

Falls für die Brückenwiderstände $R_1$ bis $R_4$ die eingangs beschriebene Abgleichbedingung erfüllt ist und die Brückenwiderstände unverstimmt bzw. die Messbrücke nicht belastet ist, ist auch bei diesem Verhältnis $(\Delta R/R)$ kompensiert das thermische Ausgangssignal wie in der bekannten Wheatstonebrücke unterdrückt. Die unvermeidliche Offsetverschiebung des Nullpunkts spielt dabei keine Rolle, da noch keine Spankompensation anliegt.

## Anpassung des $R_k$ zur Kompensation das Spanfehlers

Ist der Widerstand $R_k$ bestimmt, kann er in einer Verbindungsschaltung multipliziert und damit angepasst werden. Mit dem so angepassten Wert kann dann eine korrigierte Kompensation vorgenommen werden. Es eröffnet sich eine sehr elegante Möglichkeit, nachträglich den Kompensationswiderstand zu verändern und damit z.B. Fehlabgleiche in der Produktion zu korrigieren bzw. generell die Produktion zu vereinfachen, indem man nur noch einen grob angepassten Kompensationswiderstand verwendet und diesen nachträglich per Software anpasst. Dies ist eine elegante Lösung, Produktionskosten praktisch ohne Zusatzaufwand zu sparen.

Die Abgleichanleitung zur Kompensation des Span-Fehlers im Ausgangssignal der Messbrücke lautet:

$$\frac{\Delta R}{R} = \left(\frac{t'_1}{t'_2} - \frac{t'_3}{t'_4} - TkO\right)\frac{1}{1 + TkS\,\dfrac{2 \cdot t_k}{t'_1 + t'_2}}$$

Im Fall einer Wheatstonebrücke mit herkömmlich angepasstem Kompensationswiderstand $R_k$ gilt für den Korrekturfaktor der Temperaturkompensation des Spans TkS:

Für die Ausgestaltung der Fig. 1a, 1b: TkS = 1,
für die Ausgestaltung der Fig. 2, 3: TkS = 3/4.

Der unvermeidliche Offsetwert TkO der unverstimmten, unbelasteten Brücke wird subtrahiert, so dass das Ergebnis der unbelasteten Brücke innerhalb der Klammer über den gesamten Temperaturbereich tatsächlich null ist. Mit dieser Subtraktion kann auf die heute bei solchen Brücken üblichen Abgleichwiderstände für den Brückennullabgleich verzichtet werden. Mit dem temperaturabhängigen Korrekturbruch wird dann der Temperaturgang des Spans kompensiert, ohne einen zusätzlichen Temperaturgang am Nullpunkt zu erzeugen.

Der Abgleich, der bei der allgemein bekannten und angewandten Methode bereits während der Produktion der Messbrücke vorgenommen werden muss, kann nun in vergleichbarer Art und Weise mit der nachgeschalteten mathematischen Bestimmung vorgenommen werden:

Während bisher der Abgleich der unverstimmten, unbelasteten Brückenspannung zu null Volt geschah, erfolgt gemäß der Erfindung der Abgleich des unverstimmten, unbelasteten Brückenergebnisses dR/R durch Subtraktion von TkO zu Null. Während bisher die Applikation des passenden Kompensationswiderstands für die Kompensation des Ausgangssignals der Brücke notwendig war, wird erfindungsgemäß die passende TkS für die thermische Kompensation des Ausgangssignals der Brücke eingesetzt.

Durch kleine Variationen von TkO und TkS kann ein möglicher Resttemperaturgang einer Brücke mittels mathematischer Anpassung vollständig kompensiert werden.

## Patentansprüche

1. Verfahren zur Temperaturkompensation einer Widerstands-Messbrücke, wie insbesondere einer Weatstonebrücke, aufweisend eine Parallelschaltung zweier Widerstandsschaltkreise (3, 4) mit vier Widerständen (R1, R2, R3, R4), wobei die ersten und dritten Widerstände (R1, R3) den ersten Widerstandsschaltkreis (3) und die zweiten und vierten Widerstände (R2, R4) den zweiten Widerstandsschaltkreis (4) bilden,
wobei ein Eingangskreis (5) zwischen den ersten (R1) und zweiten (R2) Widerständen bzw. den dritten (R3) und vierten (R4) Widerständen angreift, und wobei
ein Widerstandsschaltkreis-Zweig (6) zwischen den ersten (R1) und dritten (R3) Widerständen einerseits sowie andererseits den zweiten (R2) und vierten (R4) Widerständen angreift, und geerdet wird,
wobei eine Kapazität (C) zwischen Eingangskreis (5) und Widerstandsschaltkreis-Zweig (6) angeordnet wird,
wobei die Kapazität (C) mittels Schalter (S1, S2, S3, S4, Sx, Sy, S1', S2') nacheinander über mindestens jeden Widerstand (R1, R2, R3, R4) der Messbrücke (2) entladen wird und die Entladezeiten (t1, t2, t3, t4) des Kondensators über die einzelnen Widerstände der Messbrücke (2) gemessen werden,
und wobei die temperaturabhängige relative Verstimmung der Widerstände der Messbrücke und/oder der temperaturabhängige Span-Fehler in dem Ausgangssignal der Messbrücke (2) anhand der gemessenen Entladezeiten berechnet, und zur Temperaturkompensation der Messbrücke verwendet werden.

2. Verfahren nach Anspruch 1, **dadurch gekennzeichnet, dass** die Kapazität (C) bis zum Erreichen einer Schaltschwelle eines Schwellwertschalters entladen wird.

3. Verfahren nach Anspruch 1 oder 2, **dadurch gekennzeichnet, dass** die relative Verstimmung der Widerstände der Messbrücke (2) durch

$$\left(\frac{\Delta R}{R}\right)_{kompensiert} = \frac{t'_1}{t'_2} - \frac{t'_3}{t'_4} \qquad (1)$$

bestimmt wird, wobei $t'_1$, $t'_2$, $t'_3$, $t'_4$ die Entladezeiten bzw. Entladezeitanteile der Kapazität (C) über mindestens einen der Widerstände ($R_1$, $R_2$, $R_3$, $.R_4$) der Messbrücke (2) sind.

4. Verfahren nach einem der vorangehenden Ansprüche, **dadurch gekennzeichnet, dass** der temperaturabhängige Span-Fehler in dem Ausgangssignal der Messbrücke (2) gemäß

$$\left(\frac{\Delta R}{R}\right)_{\text{Span-kompensiert}} = \left(\frac{t'_1}{t'_2} - \frac{t'_3}{t'_4} - TkO\right)\frac{1}{1 + TkS\dfrac{2 \cdot t_k}{t'_1 + t'_2}} \qquad (2)$$

kompensiert wird, wobei $t'_1$, $t'_2$, $t'_3$, $t'_4$ die Entladezeiten der Kapazität (C) über mindestens einen der Widerstände ($R_1$ $R_2$, $R_3$, $R_4$) der Messbrücke (2), TkO der Offset-Fehler der unverstimmten, unbelasteten Messbrücke (2), TkS ein Korrekturfaktor für den Span-Fehler der Messbrücke (2) und $t_k$ der Entladezeitanteil eines im Eingangskreis der Messbrücke (2) angeordneten Kompensationswiderstandes ($R_k$) ist.

5. Verfahren nach Anspruch 4, **dadurch gekennzeichnet, dass** der Korrekturfaktor TkS für den Span-Fehler der Messbrücke (2) zwischen 3/4 und 1 liegt.

6. Verfahren nach einem der vorangehenden Ansprüche, **dadurch gekennzeichnet, dass** die Entladezeitanteile ($t'_1$ $t'_2$, $t'_3$, $'_4$) mindestens eines der Widerstände ($R_1$, $R_2$, $R_3$, $R_4$) der Messbrücke (2) durch Subtraktion von Entlade-zeitanteilen von Kompensationswiderständen ($R_k$) und eventuellen Widerständen ($R_x$, $R_y$) von Analogschaltern ($S_x$, $S_y$), über die die Entladungen bei Messung von Entladezeiten über die Widerstände ($R_1$, $R_2$, $R_3$, $R_4$) der Messbrücke (2) miterfolgt sind, bestimmt werden.

7. Verfahren nach einem der vorangehenden Ansprüche, **dadurch gekennzeichnet, dass** Entladezeiten ($t_1$, $t_2$) über jeweils einen Widerstand ($R_1$, $R_2$) der Messbrücke (2) und mit diesem in Reihe stehenden Kompensationswiderstand ($t_k$) und die Entladezeiten ($t_3$, $t_4$) über jeweils einen anderen Widerstand ($R_3$, $R_4$) der Messbrücke (2) bestimmt werden.

8. Verfahren nach Anspruch 7, **dadurch gekennzeichnet, dass** der Zeitanteil ($t_k$) des Kompensationswiderstandes ($R_k$) gemäß

$$t_k \quad = R_k * C = \tfrac{1}{2} ((t_1 + t_2) - (t_3 + t_4))$$

bestimmt wird.

9. Verfahren nach Anspruch 7 oder 8, **dadurch gekennzeichnet, dass** die Kapazität (C) zusätzlich über den Kom-pensationswiderstand $R_k$ und die mit diesem in Reihe, zueinander parallel geschalteten Widerstände ($R_1$, $R_2$) der Messbrücke (2) entladen wird.

10. Verfahren nach Anspruch 9, **dadurch gekennzeichnet, dass** die Entladezeit

$$t_{12} = \left(\frac{R_1 R_2}{R_1 + R_2} + R_k\right) \cdot C$$

$$(3)$$

über den Kompensationswiderstand ($R_k$) und die mit diesem in Reihe, zueinander parallel geschalteten Widerstände ($R_1$, $R_2$) der Messbrücke (2) gemessen wird.

11. Verfahren nach Anspruch 9 oder 10, **dadurch gekennzeichnet, dass** der Zeitanteil ($t_k$) des Kompensationswider-standes ($R_k$) gemäß

$$t_k = R_k C = 2 \cdot \left(t_{12} - \frac{t_1 t_2}{t_1 + t_2}\right)$$

$$(4)$$

bestimmt wird.

12. Verfahren nach einem der Ansprüche 1 bis 9, **dadurch gekennzeichnet, dass** eine zwischen Eingangskreis (5) und Widerstandsschaltkreis-Zweig (6) der Messbrücke (2) angeordnete Kapazität (C) nacheinander über einen Widerstand ($R_1$; $R_2$; $R_3$; $R_4$) der Messbrücke (2) und den zu diesem parallel liegenden anderen Widerständen ($R_2$,... $R_4$; $R_1$, $R_3$, $R_4$; $R_1$, $R_2$, $R_4$; $R_2$... $R_4$) der Messbrücke (2) und einen mit der Messbrücke (2) in Reihe liegenden Analogschalter ($S_x$; $S_y$) entladen wird.

13. Verfahren nach Anspruch 12, **dadurch gekennzeichnet, dass** die Entladezeiten gemäß

$$t_1 = (R'_1 + R_x + R_k) * C \qquad \text{Schalter } S_x \text{ und } S_{1'} \text{ geschlossen}$$

$$t_2 = (R'_2 + R_x + R_k) * C \qquad \text{Schalter } S_x \text{ und } S_{2'} \text{ geschlossen}$$

$$t_3 = (R'_3 + R_y \qquad) * C \qquad \text{Schalter } S_y \text{ und } S_{1'} \text{ geschlossen}$$

$$t_4 = (R'_4 + R_y \qquad) * C \qquad \text{Schalter } S_y \text{ und } S_{2'} \text{ geschlossen}$$

$$(5)$$

bestimmt werden, wobei

$$R'_1 = \frac{R_1 \cdot (R_2 + R_3 + R_4)}{R_1 + R_2 + R_3 + R_4} \qquad\qquad R'_2 = \frac{R_2 \cdot (R_1 + R_3 + R_4)}{R_1 + R_2 + R_3 + R_4}$$

$$R'_3 = \frac{R_3 \cdot (R_1 + R_2 + R_4)}{R_1 + R_2 + R_3 + R_4} \qquad\qquad R'_4 = \frac{R_4 \cdot (R_1 + R_2 + R_3)}{R_1 + R_2 + R_3 + R_4}$$

$$(6)$$

ist.

14. Verfahren nach Anspruch 12 oder 13, **dadurch gekennzeichnet, dass** die Kapazität (C) zusätzlich über den Kompensationswiderstand ($R_k$), einen Analogschalter ($S_x$) mit einem Einschaltwiderstand ($R_x$) und die mit diesen in Reihe, zueinander parallel geschalteten Widerstände ($R_1$, $R_2$) entladen wird.

15. Verfahren nach Anspruch 14, **dadurch gekennzeichnet, dass** die Entladezeit gemäß

$$t_{12} = \left( \frac{R_1 R_2}{R_1 + R_2} + R_k + R_x \right) \cdot C \qquad\qquad (7)$$

bestimmt wird.

16. Verfahren nach Anspruch 15, **dadurch gekennzeichnet, dass** der Zeitanteil ($t_k$) des Kompensationswiderstandes ($R_k$) gemäß

$$t_k = R_k C = 3 \cdot \left( t_{12} - \frac{(5t_1 - t_2)(5t_2 - t_1)}{12 \cdot (t_1 + t_2)} \right) - t_x \qquad (8)$$

bestimmt wird.

17. Verfahren nach einem der Ansprüche 14 bis 16, **dadurch gekennzeichnet, dass** die Kapazität (C) über mindestens einen Analogschalter ($S_x$) mit einem Einschaltwiderstand ($R_x$) und nacheinander mit einem von zwei mit diesem in Reihe geschalteten Entladewiderstand ($R_{g1}$, $R_{g2}$) entladen wird.

18. Verfahren nach Anspruch 17, **dadurch gekennzeichnet, dass** die Entladezeiten

$$t_{g1} \quad = \quad (\ R_{g1}\ +\ R_x\ )\quad * \quad C$$
$$t_{g2} \quad = \quad (\ R_{g2}\ +\ R_x\ )\quad * \quad C \qquad (9)$$

gemessen werden.

19. Verfahren nach Anspruch 17 oder 18, **dadurch gekennzeichnet, dass** die Entladezeit der Kapazität (C) über einen Analogschalter ($S_x$) mit einem Einschaltwiderstand ($R_x$) und zwei mit diesem in Reihe und parallel zueinander geschaltete Entladewiderstände ($R_{g1}$, $R_{g2}$) entladen wird.

20. Verfahren nach Anspruch 19, **dadurch gekennzeichnet, dass** die Entladezeit der Kapazität (C) über mindestens einen Analogschalter ($S_x$) mit einem Einschaltwiderstand ($R_x$) und zwei mit diesem in Reihe, parallel zueinander geschaltete Entladewiderstände ($R_{g1}$, $R_{g2}$) gemäß

$$t_{g1-g2} = \left( \frac{R_{g1} R_{g2}}{R_{g1} + R_{g2}} + R_x \right) \cdot C \qquad (10)$$

gemessen wird.

21. Verfahren nach einem der Ansprüche 17 bis 20, **dadurch gekennzeichnet, dass** der Entladezeitanteil ($t_x$) über den Einschaltwiderstand ($R_x$) eines Analogschalters ($S_x$) gemäß

$$t_x = R_x C = 2 \cdot \left( t_{g1-g2} - \frac{t_{g1} t_{g2}}{t_{g1} + t_{g2}} \right) \qquad (11)$$

bestimmt wird.

22. Verfahren nach einem der Ansprüche 12 bis 16, **dadurch gekennzeichnet, dass** die Kapazität (C) über einen Analogschalter ($S_y$) mit einem Einschaltwiderstand ($R_y$) sowie in Reihe mit diesem, parallel zueinander angeordneten Widerständen ($R_3$, $R_4$) der Messbrücke (2) gemessen wird.

23. Verfahren nach Anspruch 22, **dadurch gekennzeichnet, dass** die Entladezeit über die Kapazität (C) über einen Analogschalter ($S_y$) mit einem Einschaltwiderstand ($R_y$) sowie in Reihe mit diesem, parallel zueinander angeordneten Widerständen ($R_3$, $R_4$) der Messbrücke (2) gemäß

$$t_{34} = \left( \frac{R_3 R_4}{R_3 + R_4} + R_y \right) \cdot C \qquad (12)$$

gemessen wird.

**24.** Verfahren nach Anspruch 21 oder 22, **dadurch gekennzeichnet, dass** der Entladezeitanteil ($t_y$) des Einschaltwiderstandes ($R_y$) des Analogschalters ($S_y$) gemäß

$$t_y = R_y C = 3 \cdot \left( t_{34} - \frac{(5t_3 - t_4)(5t_4 - t_3)}{12 \cdot (t_3 + t_4)} \right) \qquad (13)$$

bestimmt wird.

**25.** Vorrichtung zur Temperaturkompensation einer Messbrücke, insbesondere einer Wheatstonebrücke, und mit einem Kompensationswiderstand ($R_k$) in einem Eingangskreis (5), zur Durchführung des Verfahrens nach einem der vorangehenden Ansprüche,
wobei ein Eingangskreis (5) zwischen den ersten (R1) und zweiten (R2) Widerständen bzw. den dritten (R3) und vierten (R4) Widerständen angreift,
wobei ein Widerstandsschaltkreis-Zweig (6) zwischen den ersten (R1) und dritten (R3) Widerständen einerseits sowie andererseits den zweiten (R2) und vierten (R4) Widerständen angreift, und geerdet ist,
wobei eine Kapazität (C) zwischen Eingangskreis (5) und Widerstandsschaltkreis-Zweig (6) angeordnet ist, und wobei die Kapazität (C) mittels Schalter (S1, S2, S3, S4, Sx, Sy, S1', S2') nacheinander über mindestens jeden Widerstand (R1, R2, R3, R4) der Messbrücke (2) entladbar ist und die Entladezeiten (t1, t2, t3, t4) des Kondensators über die einzelnen Widerstände der Messbrücke (2) messbar sind.

**26.** Vorrichtung nach Anspruch 25, **dadurch gekennzeichnet, dass** im Eingangskreis (5) zwischen einer Spannungsquelle (7) und der Messbrücke (2) jeweils ein Analogschalter ($S_x$, $S_y$) angeordnet ist.

**27.** Vorrichtung nach Anspruch 26, **dadurch gekennzeichnet, dass** mindestens ein Analogschalter ($S_x$, $S_y$) in Reihe mit Entladewiderständen ($R_{g1}$, $R_{g2}$; $R_{g3}$, $R_{g4}$) und Entladeschaltern ($S_{g1}$, $S_{g2}$; $S_{g3}$, $S_{g4}$) liegt.

**28.** Vorrichtung nach Anspruch 26 oder 27, **dadurch gekennzeichnet, dass** mindestens ein Analogschalter ($S_x$, $S_y$) in Reihe mit zwei parallel zueinander angeordneten Entladewiderständen ($R_{g1}$, $R_{g2}$; $R_{g3}$, $R_{g4}$) liegt, denen jeweils ein Schalter ($S_{g1}$, $S_{g2}$; $S_{g3}$, $S_{g4}$) in Reihe zugeordnet ist.

**29.** Vorrichtung nach einem der Ansprüche 25 bis 28, **dadurch gekennzeichnet, dass** jeder Widerstand ($R_1$, $R_2$, $R_3$, $R_4$) der Messbrücke (2) über einen eigenen zugeordneten, in Reihe geschalteten Schalter ($S_1$, $S_2$, $S_3$, $S_4$) mit dem zugehörigen Zweig (6.1, 6.2) des Widerstandsschaltkreiskreises verbunden ist.

**30.** Vorrichtung nach einem der Ansprüche 25 bis 29, **gekennzeichnet durch** eine im Eingangskreis (5) der Messbrücke (2) angeordnete schaltbare Spannungsquelle (7).

**31.** Vorrichtung nach einem der Ansprüche 25 bis 31, **gekennzeichnet durch** eine Auswerteschaltung zur Auswertung gemessener Entladezeiten zur Temperaturkompensation der Messbrücke (2).

**Claims**

**1.** Method for the temperature compensation of a resistance measuring bridge, such as, in particular, a Wheatstone bridge, having a parallel circuit comprising two resistance circuits (3, 4) with four resistors (R1, R2, R3, R4), wherein the first and third resistors (R1, R3) form the first resistance circuit (3) and the second and fourth resistors (R2, R4) form the second resistance circuit (4),

wherein an input circuit (5) acts between the first resistor (R1) and the second resistor (R2) or between the third resistor (R3) and the fourth resistor (R4), and wherein

a resistance circuit branch (6) acts between the first resistor (R1) and the third resistor (R3), on one side, and between the second resistor (R2) and the fourth resistor (R4), on the other side, and is earthed,

wherein a capacitance (C) is arranged between the input circuit (5) and the resistance circuit branch (6),

wherein the capacitance (C) is discharged by means of switches (S1, S2, S3, S4, Sx, Sy, S1', S2') successively via at least each resistor (R1, R2, R3, R4) of the measuring bridge (2), and the discharge times (t1, t2, t3, t4) of the capacitor are measured via the individual resistors of the measuring bridge (2),

and wherein the temperature-dependent relative unbalance of the resistors of the measuring bridge and/or the temperature-dependent span error in the output signal of the measuring bridge (2) are calculated using the measured discharge times and are used for the temperature compensation of the measuring bridge.

2. Method according to claim 1, wherein the capacitor (C) is discharged until a switching threshold of a threshold switch is reached.

3. Method according to claim 1 or 2, wherein the relative unbalance of the resistors of measuring bridge (2) is determined by

$$\left(\frac{\Delta R}{R}\right)_{compensated} = \frac{t'_1}{t'_2} - \frac{t'_3}{t'_4} \tag{1}$$

in which $t'_1$, $t'_2$, $t'_3$, $t'_4$ are the discharge times or discharge time components of capacitor (C) across at least one of the resistors of the measuring bridge (2).

4. Method according to one of the preceding claims, wherein the temperature-dependent span error in the output signal of measuring bridge (2) is compensated according to

$$\left(\frac{\Delta R}{R}\right)_{span\ compensated} = \left(\frac{t'_1}{t'_2} - \frac{t'_3}{t'_4} - TkO\right)\frac{1}{1 + TkS\dfrac{2 \cdot t_k}{t'_1 + t'_2}} \tag{2}$$

in which $t'_1$, $t'_2$, $t'_3$, $t'_4$ are the discharge times of the capacitor (C) across at least one of the resistors ($R_1$, $R_2$, $R_3$, $R_4$) of measuring bridge (2), TkO the offset error of the non-unbalanced, unloaded measuring bridge (2), TkS a correction factor for the span error of measuring bridge (2) and $t_k$ the discharge time component of a compensating resistor ($R_k$) located in the input circuit of measuring bridge (2).

5. Method according to claim 4, wherein the correction factor TkS for the span error of measuring bridge (2) is between 3/4 and 1.

6. Method according to one of the preceding claims, wherein the discharge time components ($t'_1$, $t'_2$, $t'_3$, $t'_4$) of at least one of the resistors ($R_1$, $R_2$, $R_3$, $R_4$) of measuring bridge (2) are determined by subtraction of discharge time components of compensating resistors ($R_K$) and possible resistors ($R_x$, $R_y$) of analog switches ($S_x$, $S_y$) over which the discharges have taken place during the measurement of discharge times across resistors ($R_1$, $R_2$, $R_3$, $R_4$) of measuring bridge (2).

7. Method according to one of the preceding claims, wherein determination takes place of discharge times ($t_1$, $t_2$) across in each case one resistor ($R_1$, $R_2$) of measuring bridge (2) and in series therewith compensating resistor ($t_k$) and discharge times ($T_3$, $T_4$) across in each case one other resistor ($R_3$, $R_4$) of measuring bridge (2).

8. Method according to claim 7, wherein the time component ($t_k$) of compensating resistor ($R_k$) is determined according to

$$t_k = R_k * C = \tfrac{1}{2}((t_1 + t_2) - (t_3 + t_4))$$

**9.** Method according to claim 7 or 8, wherein the capacitor (C) is additionally discharged across compensating resistor ($R_k$) and the parallel-connected resistors ($R_1$, $R_2$) of measuring bridge (2) in series therewith.

**10.** Method according to claim 9, wherein the discharge time

$$t_{12} = \left( \frac{R_1 R_2}{R_1 + R_2} + R_k \right) \cdot C \qquad (3)$$

is measured across the compensating resistor ($R_k$) and the parallel-connected resistors ($R_1$, $R_2$) of measuring bridge (2) in series therewith.

**11.** Method according to claim 9 or 10, wherein the time component ($t_k$) of compensating resistor ($R_k$) is determined according to

$$t_k = R_k C = 2 \cdot \left( t_{12} - \frac{t_1 t_2}{t_1 + t_2} \right) \qquad (4)$$

**12.** Method according to one of the claims 1 to 9, wherein a capacitor placed between input circuit (5) and resistance switching circuit (6) of measuring bridge (2) is successively discharged across a resistor ($R_1, R_2, R_3, R_4$) of measuring bridge (2) and resistors ($R_2, ....R_4$; $R_1, R_3, R_4$; $R_1, R_2, R_4$; $R_2...R_4$) of measuring bridge (2) parallel thereto and an analog switch ($S_x$, $S_y$) in series with measuring bridge (2) .

**13.** Method according to claim 12, wherein the discharge times are determined according to

$$t_1 = (R'_1 + R_x + R_k) * C \qquad \text{Switches } S_x \text{ and } S_{1'} \text{ closed}$$
$$t_2 = (R'_2 + R_x + R_k) * C \qquad \text{Switches } S_x \text{ and } S_{2'} \text{ closed}$$
$$t_3 = (R'_3 + R_y \quad) * C \qquad \text{Switches } S_y \text{ and } S_{1'} \text{ closed}$$
$$t_4 = (R'_4 + R_y \quad) * C \qquad \text{Switches } S_y \text{ and } S_{2'} \text{ closed}$$

$$(5)$$

in which

$$R'_1 = \frac{R_1 \cdot (R_2 + R_3 + R_4)}{R_1 + R_2 + R_3 + R_4} \qquad R'_2 = \frac{R_2 \cdot (R_1 + R_3 + R_4)}{R_1 + R_2 + R_3 + R_4}$$

$$R'_3 = \frac{R_3 \cdot (R_1 + R_2 + R_4)}{R_1 + R_2 + R_3 + R_4} \qquad R'_4 = \frac{R_4 \cdot (R_1 + R_2 + R_3)}{R_1 + R_2 + R_3 + R_4} \qquad (6)$$

**14.** Method according to claim 12 or 13, wherein capacitor (C) is additionally discharged across compensating resistor ($R_k$), an analog switch ($S_x$) with an on-resistor ($R_x$) and the parallel-connected resistors ($R_1$, $R_2$) in series therewith.

**15.** Method according to claim 14, wherein the discharge time is determined according to

$$t_{12} = \left( \frac{R_1 R_2}{R_1 + R_2} + R_k + R_x \right) \cdot C \qquad (7)$$

**16.** Method according to claim 15, wherein the time component ($t_k$) of compensating resistor ($R_k$) is determined according to

$$t_k = R_k C = 3 \cdot \left( t_{12} - \frac{(5t_1 - t_2)(5t_2 - t_1)}{12 \cdot (t_1 + t_2)} \right) - t_x \qquad (8)$$

**17.** Method according to on of the claims 14 to 16, wherein the capacitor (C) is discharged across at least one analog switch ($S_x$) with an on-resistor ($R_x$) and successively with one of two discharge resistors ($R_{g1}$, $R_{g2}$) series-connected therewith.

**18.** Method according to claim 17, wherein the discharge times

$$t_{g1} = (R_{g1} + R_x) \quad {*}C$$
$$t_{g2} = (R_{g2} + R_x \quad {*}C \qquad (9)$$

are measured.

**19.** Method according to claim 17 or 18, wherein the discharge time of the capacitor (C) across an analog switch ($S_x$) with an on-resistor ($R_x$) and two parallel-connected discharge resistors ($R_{g1}$, $R_{g2}$) in series therewith is measured.

**20.** Method according to claim 19, wherein the discharge time of capacitor (C) across at least one analog switch ($S_x$) with an on-resistor ($R_x$) and two parallel-connected discharge resistors (Rg1, $R_{g2}$) in series therewith is measured according to

$$t_{g1-g2} = \left( \frac{R_{g1} R_{g2}}{R_{g1} + R_{g2}} + R_x \right) \cdot C \qquad (10)$$

**21.** Method according to one of the claims 17 to 20, wherein the discharge time component ($t_x$) across the on-resistor ($R_x$) of an analog switch ($S_x$) is determined according to

$$t_x = R_x C = 2 \cdot \left( t_{g1-g2} - \frac{t_{g1} t_{g2}}{t_{g1} + t_{g2}} \right) \qquad (11)$$

**22.** Method according to one of the claims 12 - 16, wherein the capacitor (C) across an analog switch ($S_y$) with an on-resistor ($R_y$) and parallel-connected resistors ($R_3$, $R_4$) if measuring bridge (2) in series therewith is measured.

**23.** Method according to claim 22, wherein the discharge time across capacitor (C) over an analog switch ($S_y$) with an on-resistor ($R_y$) and parallel resistors ($R_3$, $R_4$) of measuring bridge (2) in series therewith is measured according to

$$t_{34} = \left( \frac{R_3 R_4}{R_3 + R_4} + R_1 \right) \cdot C \qquad (12)$$

**24.** Method according to claim 21 or 22, wherein the discharge time ($t_y$) component of on-resistor ($R_y$) of analog switch ($S_y$) is determined according to

$$t_y = R_y C = 3 \cdot \left( t_{34} - \frac{(5t_3 - t_4)(5t_4 - t_3)}{12 \cdot (t_3 + t_4)} \right) \qquad (13)$$

**25.** Device for the temperature compensation of a measuring bridge, particularly a Wheatstone bridge, and with a compensating resistor ($R_k$) in an input circuit (5), for
implementing the method according to one of the preceding claims,
wherein an input circuit (5) acts between the first resistor (R1) and the second resistor (R2) or between the third resistor (R3) and the fourth resistor (R4),
wherein a resistance circuit branch (6) acts between the first resistor (R1) and the third resistor (R3), on one side, and between the second resistor (R2) and the fourth resistor (R4), on the other side, and is earthed,
wherein a capacitance (C) is arranged between the input circuit (5) and the resistance circuit branch (6), and
wherein the capacitance (C) can be discharged by means of switches (S1, S2, S3, S4, Sx, Sy, S1', S2') successively via at least each resistor (R1, R2, R3, R4) of the measuring bridge (2), and the discharge times (t1, t2, t3, t4) of the capacitor can be measured via the individual resistors of the measuring bridge (2).

**26.** Device according to claim 25, wherein there is in each case an analog switch ($S_x$, $S_y$) in input circuit (5) between a voltage supply (7) and the measuring bridge (2).

**27.** Device according to claim 26, wherein at least one analog switch ($S_x$, $S_y$) is in series with discharge resistors ($R_{g1}$, $R_{g2}$; $R_{g3}$, $R_{g4}$) and discharge switches ($S_{g1}$, $S_{g2}$; $S_{g3}$, $S_{g4}$).

**28.** Device according to claim 26 or 27, wherein at least one analog switch ($S_x$, $S_y$) is in series with two parallel discharge resistors ($R_{g1}$, $R_{g2}$; $R_{g3}$, $R_{g4}$) with which is in each case associated in series a switch ($S_{g1}$, $S_{g2}$; $S_{g3}$, $S_{g4}$).

**29.** Device according to one of the claims 25 to 28, wherein each resistor ($R_1$, $R_2$, $R_3$, $R_4$) of measuring bridge (2) is connected across its own, associated, series-connected switch ($S_1$, $S_2$, $S_3$, $S_4$) with the associated branch of the resistance switching circuit branch (6.1, 6.2).

**30.** Device according to one of the claims 25 to 29, wherein a switchable voltage supply (7) is located in input circuit (5) of measuring bridge (2).

**31.** Device according to one of the claims 25 to 30, wherein an evaluating circuit is provided for evaluating the measured discharge times for the temperature compensation of measuring bridge (2).

**Revendications**

**1.** Procédé permettant de compenser en température un pont de mesure de la résistance, s'agissant notamment d'un pont de Wheatstone, consistant à monter en parallèle deux circuits à résistances (3, 4) lesquels comportent quatre résistances (R1, R2, R3, R4), les première et troisième résistances (R1, R3) formant le premier circuit à résistances (3) et les deuxième et quatrième résistances (R2, R4) formant le deuxième circuit à résistances (4) ;

un circuit d'entrée (5) étant raccordé entre les première (R1) et deuxième (R2) résistances et entre les troisième (R3) et quatrième (R4) résistances ; et

une branche de circuit à résistances (6) étant raccordée, d'une part, entre les première (R1) et troisième (R3) résistances ainsi que, d'autre part, entre les deuxième (R2) et quatrième (R4) résistances, et étant reliée à la terre ;

un condensateur (C) étant disposé entre le circuit d'entrée (5) et la branche de circuit à résistances (6) ;

le condensateur (C) étant successivement déchargé, au moyen de commutateurs (S1, S2, S3, S4, Sx, Sy, S1[1], S2[1]), à travers au moins chacune des résistances (R1, R2, R3, R4) du pont de mesure (2), en mesurant les temps de décharge (t1, t2, t3, t4) du condensateur à travers les différentes résistances du pont de mesure (2) ;

et la dérive relative que les résistances du pont de mesure subissent en fonction de la température et/ou l'erreur de non-linéarité que le signal de sortie du pont de mesure (2) subit en fonction de la température, étant calculées à partir des temps de décharge mesurés et utilisées pour compenser en température ledit pont de mesure.

2. Procédé selon la revendication 1, **caractérisé en ce que** le condensateur (C) est déchargé jusqu'à ce qu'un commutateur à valeur de seuil atteigne un seuil de commutation.

3. Procédé selon les revendications 1 ou 2, **caractérisé en ce que** la dérive relative des résistances du pont de mesure (2) est déterminée par :

$$(\Delta R/R)_{\text{compensé}} = \frac{t'_1}{t'_2} - \frac{t'_3}{t'_4} \qquad (1)$$

$t'_1, t'_2, t'_3, t'_4$ étant les temps de décharge ou les proportions de temps de décharge du condensateur (C) à travers au moins une des résistances ($R_1, R_2, R_3, R_4$) du pont de mesure (2).

4. Procédé selon l'une quelconque des revendications précédentes, **caractérisé en ce que** l'erreur de non-linéarité que le signal de sortie du pont de mesure (2) subit en fonction de la température est compensée selon :

$$(\Delta R/R)_{\text{compensé en terme de non-linéarité}} =$$

$$\left( \frac{t'_1}{t'_2} - \frac{t'_3}{t'_4} - TkO \right) \frac{1}{1 + TkS\dfrac{2 \cdot t_k}{t'_1 + t'_2}} \qquad (2)$$

$t'_1, t'_2, t'_3, t'_4$ étant les temps de décharge du condensateur (C) à travers au moins une des résistances ($R_1, R_2, R_3, R_4$) du pont de mesure (2), TkO étant l'erreur de décalage systématique du pont de mesure (2) sans dérive ni charge, TkS étant un facteur de correction destiné à l'erreur de non-linéarité du pont de mesure (2) et $t_k$ étant la proportion de temps de décharge d'une résistance de compensation ($R_k$) disposée dans le circuit d'entrée du pont de mesure (2).

5. Procédé selon la revendication 4, **caractérisé en ce que** le facteur de correction TkS destiné à l'erreur de non-linéarité du pont de mesure (2) est compris entre 3/4 et 1.

6. Procédé selon l'une quelconque des revendications précédentes, **caractérisé en ce que** les proportions de temps de décharge ($t'_1, t'_2, t'_3, t'_4$) d'au moins une des résistances ($R_1, R_2, R_3, R_4$) du pont de mesure (2) sont déterminées par soustraction des proportions de temps de décharge concernant les résistances de compensation ($R_k$) et les éventuelles résistances ($R_x, R_y$) de commutateurs analogiques ($S_x, S_y$), à travers lesquelles sont également passées les décharges réalisées lors de la mesure de temps de décharge à travers les résistances ($R_1, R_2, R_3, R_4$) du pont de mesure (2).

7. Procédé selon l'une quelconque des revendications précédentes, **caractérisé en ce que** les temps de décharge ($t_1, t_2$) sont déterminés à travers chacune des résistances ($R_1, R_2$) du pont de mesure (2) et la résistance de compensation ($t_k$) montée en série avec celle-ci, et les temps de décharge ($t_3, t_4$) sont déterminés à travers chacune

des autres résistances ($R_3$, $R_4$) du pont de mesure (2).

8. Procédé selon la revendication 7, **caractérisé en ce que** la proportion de temps ($t_k$) de la résistance de compensation ($R_k$) est déterminée selon :

$$t_k \quad = R_k \ * \ C = \tfrac{1}{2} \ ((t_1 + t_2) - (t_3 + t_4)).$$

9. Procédé selon les revendications 7 ou 8, **caractérisé en ce que** le condensateur (C) est déchargé, de manière supplémentaire, à travers la résistance de compensation $R_k$ et les résistances ($R_1$, $R_2$) du pont de mesure (2) qui sont montées en série avec celle-ci et en parallèle l'une par rapport à l'autre.

10. Procédé selon la revendication 9, **caractérisé en ce que** le temps de décharge

$$t_{12} = \left( \frac{R_1 R_2}{R_1 + R_2} + R_k \right) \cdot C \qquad (3)$$

est mesuré à travers la résistance de compensation ($R_k$) et les résistances ($R_1$, $R_2$) du pont de mesure (2) qui sont montées en série avec celle-ci et en parallèle l'une par rapport à l'autre.

11. Procédé selon les revendications 9 ou 10, **caractérisé en ce que** la proportion de temps ($t_k$) de la résistance de compensation ($R_k$) est déterminée selon :

$$t_k = R_k C = 2 \cdot \left( t_{12} - \frac{t_1 t_2}{t_1 + t_2} \right) \qquad (4)$$

12. Procédé selon l'une quelconque des revendications 1 à 9, **caractérisé en ce qu'**un condensateur (C), disposé entre le circuit d'entrée (5) et la branche de circuit à résistances (6) du pont de mesure (2), est déchargé successivement à travers une résistance ($R_1$ ; $R_2$ ; $R_3$ ; $R_4$) du pont de mesure (2) et les autres résistances ($R_2$,... $R_4$ ; $R_1$, $R_3$, $R_4$ ; $R_1$, $R_2$, $R_4$ ; $R_2$...$R_4$) du pont de mesure (2) qui sont montées en parallèle avec celle-ci et un commutateur analogique ($S_x$ ; $S_y$) monté en série avec le pont de mesure (2).

13. Procédé selon la revendication 12, **caractérisé en ce que** les temps de décharge sont déterminés selon les équations :

$$t_1 = (R'_1 + R_x + R_k) * C \qquad \text{commutateurs } S_x \text{ et } S_1, \text{ fermés}$$
$$t_2 = (R'_2 + R_x + R_k) * C \qquad \text{commutateurs } S_x \text{ et } S_2, \text{ fermés}$$
$$t_3 = (R'_3 + R_y) * C \qquad \text{commutateurs } S_y \text{ et } S_1, \text{ fermés}$$
$$t_4 = (R'_4 + R_y) * C \qquad \text{commutateurs } S_y \text{ et } S_2, \text{ fermés}$$

$$(5)$$

dans lesquelles :

$$R_1' = \frac{R_1 \cdot (R_2 + R_3 + R_4)}{R_1 + R_2 + R_3 + R_4} \qquad R_2' = \frac{R_2 \cdot (R_1 + R_3 + R_4)}{R_1 + R_2 + R_3 + R_4}$$

$$R_3' = \frac{R_3 \cdot (R_1 + R_2 + R_4)}{R_1 + R_2 + R_3 + R_4} \qquad R_4' = \frac{R_4 \cdot (R_1 + R_2 + R_3)}{R_1 + R_2 + R_3 + R_4}$$

**14.** Procédé selon les revendications 12 ou 13, **caractérisé en ce que** le condensateur (C) est déchargé, de manière supplémentaire, à travers la résistance de compensation $R_k$, un commutateur analogique ($S_x$) pourvu d'une résistance de fermeture de circuit ($R_x$) et les résistances ($R_1$, $R_2$) qui sont montées en série avec ceux-ci, en parallèle l'une par rapport à l'autre.

**15.** Procédé selon la revendication 14, **caractérisé en ce que** le temps de décharge est déterminé selon :

$$t_{12} = \left( \frac{R_1 R_2}{R_1 + R_2} + R_k + R_x \right) \cdot C \qquad (7)$$

**16.** Procédé selon la revendication 15, **caractérisé en ce que** la proportion de temps ($t_k$) de la résistance de compensation ($R_k$) est déterminée selon :

$$t_k = R_k C = 3 \cdot \left( t_{12} - \frac{(5t_1 - t_2)(5t_2 - t_1)}{12 \cdot (t_1 + t_2)} \right) - t_x \qquad (8)$$

**17.** Procédé selon l'une quelconque des revendications 14 à 16, **caractérisé en ce que** le condensateur (C) est déchargé à travers au moins un commutateur analogique ($S_x$) pourvu d'une résistance de fermeture de circuit ($R_x$) et successivement de chacune de deux résistances de décharge ($R_{g1}$, $R_{g2}$) montées en série avec celle-ci.

**18.** Procédé selon la revendication 17, **caractérisé en ce que** les temps de décharge sont mesurés selon :

$$t_{g1} = ( R_{g1} + R_x ) * C$$
$$t_{g2} = ( R_{g2} + R_x ) * C \qquad (9)$$

**19.** Procédé selon l'une quelconque des revendications 17 ou 18, **caractérisé en ce que** le temps de décharge du condensateur (C) est déchargé à travers un commutateur analogique ($S_x$) pourvu d'une résistance de fermeture de circuit ($R_x$) et de deux résistances de décharge ($R_{g1}$, $R_{g2}$) montées en série avec celle-ci et en parallèle l'une par rapport à l'autre.

**20.** Procédé selon la revendication 19, **caractérisé en ce que** le temps de décharge du condensateur (C) est mesuré à travers au moins un commutateur analogique ($S_x$) pourvu d'une résistance de fermeture de circuit ($R_x$) et de deux résistances de décharge ($R_{g1}$, $R_{g2}$) montées en série avec celle-ci et en parallèle l'une par rapport à l'autre, selon :

$$t_{g1-g2} = \left( \frac{R_{g1} R_{g2}}{R_{g1} + R_{g2}} + R_x \right) \cdot C \qquad (10)$$

**21.** Procédé selon l'une quelconque des revendications 17 à 20, **caractérisé en ce que** la proportion de temps de décharge ($t_x$) est déterminée à travers la résistance de fermeture de circuit ($R_x$) d'un commutateur analogique ($S_x$) selon :

$$t_x = R_x C = 2 \cdot \left( t_{g1-g2} - \frac{t_{g1} t_{g2}}{t_{g1} + t_{g2}} \right) \qquad (11)$$

**22.** Procédé selon l'une quelconque des revendications 12 à 16, **caractérisé en ce que** le condensateur (C) fait l'objet d'une mesure réalisée à travers un commutateur analogique ($S_y$) pourvu d'une résistance de fermeture de circuit ($R_y$) ainsi que de résistances ($R_3$, $R_4$) du pont de mesure (2) qui sont montées en série avec celle-ci et en parallèle l'une par rapport à l'autre.

**23.** Procédé selon la revendication 22, **caractérisé en ce que** le temps de décharge du condensateur (C) est mesuré à travers un commutateur analogique ($S_y$) pourvu d'une résistance de fermeture de circuit ($R_y$) ainsi que de résistances ($R_3$, $R_4$) du pont de mesure (2) qui sont montées en série avec celle-ci et en parallèle l'une par rapport à l'autre, selon :

$$t_{34} = \left( \frac{R_3 R_4}{R_3 + R_4} + R_y \right) \cdot C \qquad (12)$$

**24.** Procédé selon les revendications 21 ou 22, **caractérisé en ce que** la proportion de temps de décharge ($t_y$) de la résistance de fermeture de circuit ($R_y$) du commutateur analogique ($S_y$) est déterminée selon :

$$t_y = R_y C = 3 \cdot \left( t_{34} - \frac{(5t_3 - t_4)(5t_4 - t_3)}{12 \cdot (t_3 + t_4)} \right) \qquad (13)$$

**25.** Dispositif permettant de compenser en température un pont de mesure, s'agissant notamment d'un pont de Wheatstone, et comportant une résistance de compensation ($R_k$) dans un circuit d'entrée (5), destiné à mettre en oeuvre le procédé selon l'une quelconque des revendications précédentes ;
un circuit d'entrée (5) étant raccordé entre les première (R1) et deuxième (R2) résistances et entre les troisième (R3) et quatrième (R4) résistances ;
une branche de circuit à résistances (6) étant raccordée, d'une part, entre les première (R1) et troisième (R3) résistances ainsi que, d'autre part, entre les deuxième (R2) et quatrième (R4) résistances, et étant mise à la terre ;
un condensateur (C) étant disposé entre le circuit d'entrée (5) et la branche de circuit à résistances (6) ; et le condensateur (C) pouvant être successivement déchargé, au moyen de commutateurs (S1, S2, S3, S4, Sx, Sy, S1', S2'), à travers au moins chacune des résistances (R1, R2, R3, R4) du pont de mesure (2), et les temps de décharge (t1, t2, t3, t4) du condensateur pouvant être mesurés à travers les différentes résistances du pont de mesure (2).

**26.** Dispositif selon la revendication 25, **caractérisé en ce qu'**un commutateur analogique ($S_x$, $S_y$) est disposé dans le circuit d'entrée (5), à chaque fois entre une source de tension (7) et le pont de mesure (2).

**27.** Dispositif selon la revendication 26, **caractérisé en ce qu'**au moins un commutateur analogique ($S_x$, $S_y$) est situé en série avec des résistances de décharge ($R_{g1}$, $R_{g2}$ ; $R_{g3}$, $R_{g4}$) et des commutateurs de décharge ($S_{g1}$, $S_{g2}$ ; $S_{g3}$, $S_{g4}$).

**28.** Dispositif selon les revendications 26 ou 27, **caractérisé en ce qu'**au moins un commutateur analogique ($S_x$, $S_y$) est situé en série avec deux résistances de décharge ($R_{g1}$, $R_{g2}$ ; $R_{g3}$, $R_{g4}$) lesquelles sont disposées en parallèle l'une par rapport à l'autre, un commutateur ($S_{g1}$, $S_{g2}$ ; $S_{g3}$, $S_{g4}$) monté en série étant associé à chacune de ces dernières.

29. Dispositif selon l'une quelconque des revendications 25 à 28, **caractérisé en ce que** chacune des résistances ($R_1$, $R_2$, $R_3$, $R_4$) du pont de mesure (2) est reliée, par l'intermédiaire de son propre commutateur ($S_1$, $S_2$, $S_3$, $S_4$) monté en série et lui étant associé, à la branche concernée (6.1, 6.2) du circuit à résistances.

30. Dispositif selon l'une quelconque des revendications 25 à 29, **caractérisé par** une source de tension (7) commutable qui est disposée dans le circuit d'entrée (5) du pont de mesure (2).

31. Dispositif selon l'une quelconque des revendications 25 à 31, **caractérisé par** un circuit d'analyse destiné à analyser les temps de décharge mesurés pour ainsi compenser en température le pont de mesure (2).

Fig. 1a

Fig. 1b

Fig. 2

Fig.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1251357 A1